# EUROPÄISCHE PATENTSCHRIFT

(11) **EP 2 367 965 B1**
(45) Veröffentlichungstag und Bekanntmachung des Hinweises auf die Patenterteilung: **09.01.2019**
(21) Anmeldenummer: 09818654.7
(22) Anmeldetag: 20.11.2009
(51) Int. Cl.: C23C 18/12

(54) **LEITFÄHIGE BESCHICHTUNGEN AUF ITO-BASIS**
CONDUCTIVE ITO BASED COATING
REVÊTEMENTS CONDUCTEURS À BASE D'OXYDE D'INDIUM-ÉTAIN

(30) Priorität: 20.11.2008 DE 102008058365
(43) Veröffentlichungstag der Anmeldung: 28.09.2011
(73) Patentinhaber: Leibniz-Institut für Neue Materialien gemeinnützige GmbH, 66123 Saarbrücken (DE)
(72) Erfinder: de OLIVEIRA, Peter William,, 66123 Saarbrücken (DE); HEUSING, Sabine, 66440 Blieskastel (DE); SCHNEIDER, Heike, 66130 Saarbrücken (DE); QUILITZ, Mario, 66280 Sulzbach-Neuweiler (DE); VEITH, Michael, 66386 St. Ingbert (DE)
(74) Vertreter: Patentanwälte Gierlich & Pischitzis Partnerschaft mbB
(86) Internationale Anmeldenummer: PCT/EP2009/008280
(87) Internationale Veröffentlichungsnummer: WO 2010/057653

(56) Entgegenhaltungen:
- DE-A1- 19 849 048
- JP-A- 8 067 837
- US-A- 5 518 810

## Beschreibung

### Gebiet der Erfindung

Die Erfindung betrifft Beschichtungen auf der Basis von Indium-Zinn-Oxid.

### Stand der Technik

Indium-Zinn-Oxide sind durch ihre optoelektronischen Eigenschaften gekennzeichnet. Sie sind z. B. in Form von dünnen transparenten Schichten in der Lage, Infrarotlicht zu reflektieren und zeichnen sich gleichzeitig durch eine relativ hohe elektronische Leitfähigkeit bei vorhandener Transparenz in Schichtsystemen aus.

Aus diesem Grunde gibt es sehr viele Anwendungsmöglichkeiten für Indium-Zinn-Oxid (ITO)-Systeme, und dementsprechend auch sehr viele Untersuchungen zu ihrer Herstellung.

Die gängigsten Verfahren zum Auftragen von transparenten Schichten sind Gasphasentechniken, bei denen das ITO aus der Gasphase auf das Substrat in Form einer zusammenhängenden dünnen Schicht abgeschieden wird. Als andere Verfahren werden der Sol-Gel-Prozess oder Pulver- und Pastentechnologien verwendet.

Das Stoffsystem Indium und Sauerstoff ist durch eine Vielzahl von Verbindungen gekennzeichnet. Die thermodynamisch stabilste ist In₂O₃. Indiumoxide der Zusammensetzung In₄O₃, In₄O₅, In₂O und In₇O₉ werden üblicherweise durch Reduktion von In₂O₃ in Wasserstoffstrom gebildet. In₂O₃ ist bei Zimmertemperatur dunkelgelb bis hellgelb, bei höheren Temperaturen braun bis braunrot und in Mineralsäuren löslich. Röntgenographisch kann nur die kubische Modifikation nachgewiesen werden.

Indiumoxid ist ein wide-gap n-Halbleiter, dessen intrinsische Elektronenleitung auf Sauerstofffehlstellen beruht. Die Mobilität der Ladungsträger wird neben intrakristallinen Effekten vor allem durch die Behinderung interkristalliner Elektronenübergänge beschränkt. Eine Möglichkeit, die geringe Ladungsträgerdichte des reinen Indiumoxids zu erhöhen, ist der gezielte Einbau von vierwertigen Elementen wie z. B. Zinn.

In den letzten Jahren hat das Interesse an einer definierten Herstellung und Anwendung transparenter leitfähiger Schichten auf verschiedenen Substraten stark an Bedeutung gewonnen. Während die Anwendung Sb-und F-dotierter Zinnoxidschichten auf Glassubstraten aufgrund ihrer Leitfähigkeit, ihrer Transparenz im sichtbaren Spektralbereich und ihrer Reflektionseigenschaften im IR-Bereich für die Oberflächenbeheizung von Gläsern für Flugzeuge, Raumschiffe, Kameras und auch für elektrostatische Abschirmzwecke schon lange bekannt ist, sind in neuerer Zeit vielfältige Anforderungen an derartige Schichten für die Anwendungen in der Mikro- und Optoelektronik entstanden. Dazu gchören z. B.
1. transparente Ansteuerelektroden für Flüssigkeitsdisplays, Dünnfilmelektrolumineszenz-Displays und Elektrochromie-Displays.
2. transparente leitfähige Schichten für hochempfindliche Strahlungsdetektoren, ferroelektrische Photoleiter und Speicheranordnungen.
3. transparente leitfähige Oxidfilme als Gate-Elektroden für Ladungs-, Injektions- und ladungsgekoppelte Anordnungen.

Diese Anwendungen in der Optoelektronik sind gleichfalls mit höheren Anforderungen an die Leitfähigkeit, Transparenz und Strukturierbarkeit der Schichten verbunden. Aufgrund der ungünstigen Strukturierungseigenschaften dotierter Zinnoxidschichten bei der üblichen Strukturierung durch chemische Ätztechnologien haben sich für diese Anwendungen überwiegend zinndotierte Indiumoxidschichten (ITO) durchgesetzt.

Weiterhin zeigen diese ITO-Schichten im Vergleich zu dotierten Zinnoxidschichten eine wesentlich bessere Leitfähigkeit und Transparenz. Zinndotierte Indiumoxidschichten stellen zurzeit die leitfähigsten Beschichtungen dar, die kommerziell erhältlich sind. Im Routinebetrieb liegt der erreichbare spezifische Widerstand bei etwa 1-2 x 10⁴ Ohm.cm, was in Verbindung mit einer etwa 30 nm dicken Sperrschicht aus SiO₂ bereits bei 120 nm Schichtdicke zu einem Flächenwiderstand von 15 Ohm/sq führt. (Transparenz > 90%). Bedingt durch die Herstellung im Sputter- bzw. CVD-Verfahren sind die Kosten für diese Art der Beschichtung vergleichsweise hoch und großflächige Beschichtungen sind nur schwer durchzuführen.

Die hohe Ladungsträgerdichte in Verbindung mit einer Ladungsträgermobilität im Bereich von 40-60 cm²/Vs führt zu einer sehr hohen Transparenz im sichtbaren Bereich, bei gleichzeitig hervorragender Reflexion im IR-Bereich. Der Anteil an Zinnoxid liegt üblicherweise zwischen 7-12 Gew. %.

US 5,518,810 betrifft die Herstellung von speziellen IRblockierenden Materialien auf ITO-Basis insbesondere in Polymeren.

JP 8 067837 und DE 198 49 048 offenbaren Verfahren zur Herstellung einer Beschichtung unter Verwendung einer Zusammensetzung enthaltend ITO-Partikel.

Zur Herstellung von leitfähigen und/oder transparenten Beschichtungen auf ITO-Basis werden daher häufig Suspensionen von ITO-Partikeln verwendet. Um dabei eine hohe Transparenz zu gewährleisten ist es notwendig, dass die eingesetzten Partikel nicht nur eine durchschnittliche Teilchengröße von nicht mehr als 200 nm aufweisen, sondern auch, dass sie in der Suspension im wesentlichen keine Agglomerate bilden, sondern die Primärpartikelgröße praktisch erhalten bleibt.

Aus Kostengründen ist gerade für die Massenherstellung ein möglichst geringer Gehalt an Indium von großem Interesse.

Da gerade in der Optoelektronik sehr hohe Anforderungen an die eingesetzten Materialien gestellt werden, reichen die Zusammensetzungen aus dem Stand der Technik nicht aus, um transparente und/oder leitfähige Schichten auf ITO-Basis mit verringertem Indiumgehalt herzustellen. In der aktuellen Entwicklung spielt gerade die Leitfähigkeit von besonders dünnen Schichten eine wichtige Rolle.

### Aufgabe

Aufgabe der Erfindung ist es, ein Verfahren zur Herstellung von Beschichtungen auf Indium-Zinn-Oxid-Basis anzugeben, welches es erlaubt transparente und/oder leitfähige Schichten mit sehr vorteilhaften Eigenschaften und reduziertem Gehalt an Indium herzustellen.

### Lösung

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet. Der Wortlaut sämtlicher Ansprüche wird hiermit durch Bezugnahme zum Inhalt dieser Beschreibung gemacht. Die Erfindung umfasst auch alle sinnvollen und insbesondere alle erwähnten Kombinationen von unabhängigen und/oder abhängigen Ansprüchen.

Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.

Die Aufgabe wird überraschenderweise durch ein Verfahren zur Herstellung von Beschichtungen und/oder Formkörpern auf der Basis von Indium-Zinn-Oxid (ITO) enthaltend folgende Schritte gelöst:
a) Herstellung einer Zusammensetzung enthaltend
   a1) ITO-Nanopartikel; und
   a2) mindestens eine hydrolysierbare Verbindung der 4., 5., 6., 13. oder 14. Gruppe des Periodensystems;
   a3) mindestens ein organisch modifiziertes anorganisches Bindemittel;
b) Auftragen der Beschichtungszusammensetzung auf ein Substrat oder Einbringen der Zusammensetzung in einer Form;
c) Härten der Zusammensetzung.

Es wurde gefunden, dass durch das angegebene Verfahren erhaltene Beschichtungen oder Formkörper eine verbesserte spezifische Leitfähigkeit oder Transparenz wie Beschichtungen oder Formkörper aus Zusammensetzungen nur aus ITO aufweisen. Dabei werden Beschichtungen oder Formkörper verglichen, welche aus Zusammensetzungen mit dem ähnlichem Anteil in Gew.-% an ITO hergestellt wurden. Durch die Erfindung können Beschichtungen und Formkörper mit verringertem Gehalt an ITO hergestellt werden, welche gleiche oder verbesserte Eigenschaften aufweisen. Von besonderer Bedeutung ist dabei die Leitfähigkeit der hergestellten Beschichtungen und Formkörper. Zusätzlich werden die optischen Eigenschaften kaum verändert.

Unter Indium-Zinn-Oxid-Nanopartikeln werden Nanopartikel verstanden, welche im Wesentlichen aus einem Mischoxid von Indium und Zinn bestehen. Das Indium und das Zinn können darin in einer oder in verschiedenen Oxidationsstufen vorliegen. Beispielsweise liegen In (+I) und/oder In (+III) sowie Sn (+II) und/oder Sn (+IV) vor. Sn liegt bevorzugt als Sn (+IV) vor. Gegebenenfalls können Indium und Zinn auch teilweise als In (0) oder Sn (0) vorliegen. Die ITO-Nanopartikel können auch oberflächenmodifiziert sein.

Bevorzugt handelt es sich bei dem ITO-Pulver um ein zinndotiertes Indiumoxid, d. h. der Anteil an Zinnoxid ist geringer als der Anteil an Indiumoxid. Der Anteil an Zinnoxid bezogen auf das Indium-Zinn-Oxid, ohne Berücksichtigung der oberflächenmodifizierenden Komponenten, beträgt beispielsweise 2 bis 30 Mol-%, bevorzugt 5 bis 12 Mol-%. Die ITO-Nanopartikel können beispielsweise, ohne Berücksichtigung der oberflächenmodifizierenden Komponente, durch die Formel In_{2-y}Sn_{y}O₃ mit 0 ≤ y ≤ 2 insbesondere 0 ≤ y ≤ 1 ausgedrückt werden (Ladungsüberschuss: e⁻_{y}).

Selbstverständlich kann das Indium-Zinn-Oxid-Pulver Verunreinigungen enthalten.

Der akzeptierbare Grad hängt vom Verwendungszweck ab. Über die Edukte kann z. B. SO₄²⁻ , Co, Cu, Fe, Ni, Pb, Zn, K oder Na enthalten sein. Durch Verwendung reiner Edukte können SO₄²⁻, Ca, Co, Cu, Fe, Ni, Pb und Zn auf unter 0,005 Gew.-% und Na, K auf unter 0,01 Gew. % gebracht werden. Über das Verfahren kann z. B. NH₄⁺ und Cl⁻ in das Produkt gelangen, das je nach Anzahl der Waschzyklen praktisch gänzlich entfernt werden kann. Bezogen auf das Indium-Zinn-Oxid-Pulver sind aber unter Berücksichtigung der oberflächenmodifizierenden Komponente weniger als 5 Gew.-%, bevorzugt weniger als 1 Gew.-%, insbesondere bevorzugt weniger als 0,1 Gew.-% Verunreinigungen enthalten.

Die ITO-Nanopartikel weisen bevorzugt eine durchschnittliche Teilchengröße von bevorzugt nicht mehr als 200 nm, insbesondere nicht mehr als 50 nm und besonders bevorzugt nicht mehr als 30 nm auf. Ein besonders bevorzugter Bereich liegt bei 5 bis 30 nm.

Bevorzugt sind ITO-Nanopartikel, welche durch Fällung von Indium-Zinn-Vorstufen in Gegenwart einer oder mehrerer oberflächenmodifizierender Komponenten, nachträglicher Calcinierung und folgender Zerkleinerungs- oder Dispergierbehandlung erhalten werden.

Als oberflächenmodifizierende Komponenten können beispielsweise Mono- oder Polycarbonsäuren, Diketone, Aminosäuren, Polyethylenoxidderivate, Amine oder Säureamide oder Mischungen aus zwei oder mehreren dieser Komponenten eingesetzt werden.

Beispiele für weitere geeignete oberflächenmodifizierenden Komponenten sind Mono- und Polyamine, insbesondere solche der allgemeinen Formel R₃₋ₙNHₙ, worin n = 0,1 oder 2 und die Reste R unabhängig voneinander Alkylgruppen mit 1 bis 12, insbesondere 1 bis 6 und besonders bevorzugt 1 bis 4 Kohlenstoffatomen darstellen (z. B. Methyl, Ethyl, n-und i-Propyl und Butyl) und Polyethylenamine ; β-Dicarbonylverbindungen mit 4 bis 12, insbesondere 5 bis 8 Kohlenstoffatomen ; Organoalkoxysilane, wie z. B. diejenigen, die zur Oberflächenmodifizierung von kolloidaler Kieselsäure eingesetzt werden (z. B. solche der aligemeinen Formel R₄₋ₘSi(OR')ₘ worin die Gruppen R und R' unabhängig voneinander C₁-C₄-Alkyl darstellen und m 1, 2, 3 oder 4 ist und modifizierte Alkoholate, bei denen ein Teil der OR-Gruppen (R wie oben definiert) durch inerte organische Gruppen substituiert ist und über die noch vorhandenen OR-Gruppen eine Anbindung (Kondensation) auf der Partikeloberfläche erfolgt und die organischen Gruppen die Abschirmung übernehmen. Beispiele hierfür sind z. B. Zirkon-und Titanalkoholate M(OR)₄ (M = Ti, Zr), bei denen ein Teil der OR-Gruppen durch einen Komplexbildner, wie z. B. eine β-Dicarbonylverbindung oder eine (Mono)carbonsäure ersetzt ist.

Eine weitere Gruppe von verwendbaren oberflächenmodifizierenden Komponenten sind Tenside, z. B. kationische, anionische, nicht-ionische und amphotere Tenside.

Bevorzugt werden nicht-ionische Tenside, wobei Polyethylenoxid-derivate besonders bevorzugt sind. Es kann sich dabei z. B. um Derivate mit gesättigten oder ungesättigten (Mono)carbonsäuren handeln, insbesondere mit Carbonsäuren mit mehr als 7, bevorzugt mehr als 11 Kohlenstoffatomen, z. B. Polyethylenoxidderivate mit Stearin-, Palmitin- oder Ölsäure, etwa die unter der Marke "Emulsogen" erhältlichen Produkte. Es kann sich auch um Derivate mit Sorbitanestern (Sorbitan + Carbonsäure) handeln, wobei als Carbonsäure beispielsweise die vorstehend genannten in Frage kommen. Diese Produkte sind im Handel unter der Marke "Tween" erhältlich. Weiter können Polyethylenoxid(mono)-alkylether, beispielsweise mit Alkoholen mit mehr als 7, bevorzugt mehr als 11 Kohlenstoffatomen verwendet werden, z. B. die unter der Marke "Brij" erhältlichen Produkte.

### Konkrete Beispiele für einsetzbare oberflächenmodifizierende Komponenten sind

a. Mono- und Polycarbonsäuren wie Ameisensäure, Essigsäure, Propionsäure, Buttersäure, Pentansäure, Hexansäure, Acrylsäure, Methacrylsäure, Crotonsäure, Citronensäure, Adipinsäure, Bernsteinsäure, Glutarsäure, Oxalsäure, Maleinsäure, Fumarsäure, Itaconsäure, Stearinsäure und insbesondere 3,6,9-Trioxadecansäure sowie die entsprechenden Anhydride,
b. Diketone wie Acetylaceton, 2,4-Hexandion, 3,5-Heptandion, Acetessigsäure, Acetessigsäure-C₁-C₄-Alkylester wie Acetessigsäureethylester, Diacetyl und Acetonylaceton,
c. Aminosäuren, insbesondere β-Alanin, aber auch Glycin, Valin, Aminocapronsäure, Leucin und Isoleucin,
d. Polyethylenoxid-Derivate, insbesondere Tween 80 (Sorbitanmonooleat-polyoxyalkylen), aber auch Emulsogen® (Hexaglycolmonostearat), Emulsogen® OG (Ölsäurederivat) und Brij® 30 (Polyoxyethylenlaurylether),
e. Säureamide, insbesondere Caprolactam, und
f. Amine wie z. B. Methylamin, Dimethylamin. Trimethylamin, Anilin, N-Methylanilin, Diphenylamin, Triphenylamin, Toluidin, Ethylendiamin, Diethylentriamin.

Diese oberflächenmodifizierenden Komponenten können einzeln oder als Mischung eingesetzt werden. Besonders bevorzugte Verbindungen sind 3,6,9-Trioxadecansäure, β-Alanin, Tween® 80 und Caprolactam.

Der Anteil der oberflächenmodifizierenden Komponente(n), bezogen auf die ITO-Partikel, liegt bevorzugt zwischen 2 und 30 Gew.-%, besonders bevorzugt zwischen 2 und 7 Gew.-%.

Die nach der Fällung erhaltenen Partikel werden calciniert, beispielsweise bei Temperaturen zwischen 200 und 400 °C, bevorzugt zwischen 230 und 280 °C, besonders bevorzugt bei 250 °C. Die isotherme Haltezeit beträgt beispielsweise zwischen 15 und 120 Minuten, bevorzugt zwischen 45 und 90 Minuten, besonders bevorzugt 60 Minuten. Die Calcinierung erfolgt bevorzugt unter reduzierenden Bedingungen, wobei ebenfalls die vorstehend benannten Verfahrensbedingungen zur Anwendung kommen. Die reduzierenden Bedingungen werden bevorzugt durch Durchleiten eines reduzierenden Gases/Gasgemisches oder eines reduzierenden Dampfes erhalten. Vor Einsatz der reduzierenden Komponente kann der Ofen mit einem Inertgas, z. B. Stickstoff gespült werden. Als reduzierendes Gas/Gasgemisch oder reduzierender Dampf kann beispielsweise Kohlenmonoxid, Kohlenmonoxid/ Stickstoff, eine Wasserdampf-Atmosphäre oder Formiergas (Wasserstoff/Stickstoff) verwendet werden. Dabei ist die Verwendung von Formiergas besonders bevorzugt. Der eingesetzte Gasfluss hängt von der Menge des zu calcinierenden Pulvers und der reduzierenden Komponente ab.

Falls die Calcinierung nicht unter reduzierenden Bedingungen durchgeführt wurde, kann die Reduktion auch nach der Calcinierung durchgeführt werden, beispielsweise in einem späteren Verfahrensschritt des erfindungsgemäßen Verfahrens.

Die bevorzugten ITO-Nanopartikel werden danach durch eine Zerkleinerungs- oder Dispergierbehandlung aus dem calcinierten Pulver erhalten, wobei weitere oberflächenmodifizierende Komponenten und/oder weitere Lösungsmittel zugegeben werden. Bevorzugt handelt es sich um eine mechanische Zerkleinerungsbehandlung. Bevorzugt ist außerdem der Zusatz oberflächenmodifizierender Komponenten, insbesondere 3,6,9-Trioadecansäure. Bezogen auf das calcinierte Pulver wird die oberflächenmodifizierende Komponente, bevorzugt in einer Menge von 2 bis 30 Gew.-%, besonders bevorzugt von 2-10 Gew.-% zugegeben.

Bei der Zerkleinerungsbehandlung kann auch noch ein oder mehrere Lösungsmittel zugegeben werden. Bevorzugt werden als Lösungsmittel hochsiedende Flüssigkeiten, z.B. Flüssigkeiten mit einem Siedepunkt von über 120 °C, bevorzugt über 150 °C. Bevorzugt werden hochsiedende Glycole oder Glycolether eingesetzt, bevorzugt Ethylen-, Propylen- oder Butylenglycol oder die entsprechenden Di-, Tri-, Tetra-, Penta- oder Hexamere, sowie die entsprechenden Mono- oder Diether wobei eine oder beide Hydroxygruppen durch z.B. eine Methoxy-, Ethoxy-, Propoxy- oder Butoxygruppe ersetzt sind. Selbstverständlich können auch Mischungen dieser Lösungsmittel eingesetzt werden.

Das Lösungsmittel kann bei der Zerkleinerung oder Dispergierung bezogen auf das eingesetzte Indium-Zinn-Oxid-Pulver, in einer Menge von 5 bis 150 Gew.-%, bevorzugt 10 bis 100 Gew.-%, besonders bevorzugt zwischen 30 bis 50 Gew.-% zugegeben werden. Ein besonders bevorzugtes Verhältnis ist 75:25. Bevorzugt wird die Menge des Lösungsmittels so gewählt, dass pastöse, bzw. hochviskose Suspensionen erhalten werden. Alternativ können auch durch Entfernen des Lösungsmittels Pulver erhalten werden.

Auf diese Weise hergestellte Partikel zeichnen sich insbesondere dadurch aus, dass sie im Wesentlichen auf Primärgröße redispergierbar.sind.

Solche Partikel sind beispielsweise in der Schrift WO 00/14017 A1 der Anmelderin beschrieben.

Die Zusammensetzung enthält eine hydrolysierbare Verbindung der Gruppen 4., 5., 6., 13. oder 14. des Periodensystems. Die Zusammensetzung kann 1 bis 80 Gew.-% dieser Verbindung bezogen auf den Gehalt an ITO enthalten, bevorzugt sind 1 bis 30 Gew.-%, besonders bevorzugt sind 3 bis 15 Gew.-%, insbesondere 5 bis 10 Gew.-% bezogen auf den ITO Gehalt, wobei der optimale Gehalt an dieser Verbindung vom ITO Gehalt abhängt, da er auf den ITO Gehalt bezogen wird. Abhängig vom Gehalt an ITO kann der optimale Bereich variieren. Bevorzugt wird der Gehalt der hydrolysierbaren Verbindung auf das ihr entsprechende Oxid bezogen, z.B. im Falle von Ti(OR)₄ auf TiO₂). Dies ist in der Regel das Oxid der stabilsten Oxidationsstufe dieser Verbindung. Bevorzugt handelt es sich dabei um Verbindungen der Formel MXₐ, wobei M ein Metall der 4., 5., 6., 13. oder 14. des Periodensystems ist (Si ist dabei kein Metall), wie beispielsweise B, Al, Ga, In, Tl, Ge, Sn, Pb, Ti, Zr, Hf, V, Nb, Ta, Cr, Mo, W. Bevorzugt ist M Sn, Ti, Al oder Zr, besonders bevorzugt Ti. X ist ein hydrolysierbarer Rest, wie beispielweise Halogenatome (insbesondere Chlor und Brom), Alkoxygruppen, Alkylcarbonylgruppen oder Acyloxygruppen, wobei Alkoxygruppen, insbesondere C₁₋₄-Alkoxygruppen, besonders bevorzugt Ethoxy-, Propoxy-, Isopropoxy-, n-Butoxy-, iso-Butoxy-Gruppen, bevorzugt sind. a entspricht der Wertigkeit von M. Bevorzugt eingesetzte Titanate sind Ti(OCH₃)₄, Ti(OC₂H₅)₄ und Ti (n-oder i-OC₃H₇)₄. Es können auch Mischungen eingesetzt werden.

Der Gehalt an ITO-Partikeln in der gehärteten Schicht oder dem gehärteten Formkörper liegt bevorzugt bei über 70 Gew.-%, besonders bevorzugt über 75 Gew.-% oder über 80 Gew.-%, aber unter 95 Gew.-% oder unter 90 Gew.-%, insbesondere zwischen 70 Gew.-% und 95 Gew.-%, bevorzugt zwischen 75 Gew.-% und 90 Gew.-%. Bei Verwendung eines organisch modifizierten anorganischen Bindemittels bezogen auf die anorganischen Bestandteile des Bindemittels. Unter anorganischen Bestandteilen wird dabei das Oxid des Bindemittels und das Oxid der hydrolysierbaren Verbindung verstanden.

Die ITO-Nanopartikel und die hydrolysierbare Verbindung können auf beliebige dem Fachmann bekannte Arten miteinander vermischt werden. Bevorzugt ist die Vermischung einer Dispersion oder eines Sols der ITO-Partikel und die eines Sols der hydrolysierbaren Verbindung. Die ITO-Nanopartikel können sowohl direkt aus dem Herstellungsverfahren, als auch als Pulver hinzugefügt werden. Als Lösungsmittel können geeignete dem Fachmann bekannte Lösungsmittel verwendet werden. Bevorzugt sind organische Lösungsmittel. Als organische Lösungsmittel eignon sich sowohl polare als auch unpolare und aprotische Lösungsmittel. Beispiele hierfür sind Alkohole, wie z. B. aliphatische Alkohole mit 1 bis 6 Kohlenstoffatomen (insbesondere Methanol, Ethanol, n-und i-Propanol, 2-Isopropoxyethanol und Butanol); Ketone, wie z. B. Aceton und Butanon ; Ester, wie z. B. Essigsäureethylester ; Ether, wie z. B. Diethylether, Tetrahydrofuran und Tetrahydropyran ; Amide, wie z. B. Dimethylacetamid und Dimethylformamid ; Sulfoxide und Sulfone, wie z. B. Sulfolan und Dimethylsulfoxid ; und aliphatische (gegebenenfalls halogenierte) Kohlenwasserstoffe, wie z. B. Pentan, Hexan und Cyclohexan. Selbstverständlich können auch Mischungen derartiger Lösungsmittel eingesetzt werden.

Abhängig von der Verwendung der Zusammensetzung können auch noch nach der Vermischung Lösungsmittel entfernt oder hinzugefügt werden, beispielsweise um eine bestimmte Viskosität einzustellen.

Zusätzlich kann die Zusammensetzung noch übliche Additive, wie Benetzungsmittel, Stabilisatoren, Sensibilisatoren oder ähnlich enthalten, bevorzugt unter 5 Gew.-% bezogen auf die Zusammensetzung.

Die Zusammensetzung kann noch zusätzlich noch ein oder mehrere Bindemittel enthalten. Die Bindemittel können in einer Menge zugegeben werden, dass der Füllgrad an ITO und dem Hydrolyseprodukt der hydrolysierbaren Verbindung von 1 bis 95 Vol.-%, bevorzugt 5 bis 80 Vol.-% ergibt. Unter Füllgrad wird dabei die Menge an ITO und Oxid der hydrolysierbaren Verbindung in Vol.-% bezogen auf den Gesamtfeststoffgehalt der nach Härtung, bzw. Trocknung der Zusammensetzung verstanden. In der gehärteten, bzw. getrockneten Zusammensetzung kann der Gehalt an Bindemittel bezogen auf die anorganischen Bestandteile zwischen 1 und 20 Gew.-% der Schicht betragen, bevorzugt zwischen 3 und 10 Gew.-% bezogen auf das Oxid des jeweiligen Bindemittels (z. B. SiO₂ im Falls von Silanen).

Dabei kann beispielsweise auch das Bindemittel bereits bei der Zerkleinerungsbehandlung der bevorzugten ITO-Nanopartikel zugegeben werden. Prinzipiell kann das Bindemittel, sofern es eine geeignete Viskosität aufweist, auch anstelle eines Lösungsmittels verwendet werden.

Als Bindemittel können prinzipiell alle dem Fachmann bekannten organisch modifizierten anorganischen Bindemittel oder Mischungen davon eingesetzt werden. Beispiele für organisch modifizierte anorganische Bindemittel sind Polyorganosiloxane bzw. Silicon-Lacke. Die Polyorganosiloxane bzw. die Silicon-Lacke werden bevorzugt nach dem Sol-Gel- Verfahren hergestellt (Sol-Gel-Lack). Zur Herstellung werden bevorzugt hydrolysierbare Silane verwendet. Die hydrolysierbaren Silane können bevorzugt nicht hydrolysierbare Reste aufweisen. Das organisch modifizierte anorganische Bindemittel umfasst daher mindestens ein hydrolysierbares Silan mit mindestens einem nicht hydrolysierbaren Rest.

Bei den hydrolysierbaren Silanen handelt es sich bevorzugt um Silane der allgemeinen Formel RₙSiX₄₋ₙ. Bei der oder den Gruppen X, die gleich oder verschieden sein können, und vorzugsweise identisch sind, handelt es sich um hydrolysierbare Reste, bei R handelt es sich um nicht hydrolysierbare Reste. Die Reste X werden vorzugsweise aus Halogenatomen (insbesondere Chlor und Brom), Alkoxygruppen, Alkylcarbonylgruppen und Acyloxygruppen ausgewählt, wobei Alkoxygruppen, insbesondere C₁₋₄-Alkoxygruppen wie Methoxy und Ethoxy besonders bevorzugt sind. n kann die Werte 1, 2 oder 3, vorzugsweise 1 oder 2 und besonders bevorzugt 1, annehmen. Die eingesetzten hydrolysierbaren Silane können auch vollständig hydrolysierbare Silane der obigen Formel, in der n gleich 0 ist, umfassen, vorzugsweise in einem Anteil von weniger als 50 Mol-% auf Basis aller eingesetzten monomeren hydrolysierbaren Silane.

Die Gruppe R oder die Gruppen R, die gleich oder verschieden sein können, können Alkyl, Alkenyl, Aryl, Alkylaryl, Arylalkyl oder R'Y sein. R' ist geradkettiges oder verzweigtes Alkylen, durch Sauerstoff-oder Schwefelatome oder NH-Gruppen unterbrochen sein kann, Phenylen, Alkylphenylen oder Alkylenphenylen. Y ist die funktionelle Gruppe, über die eine Vernetzung möglich ist. Beispiele für Y sind gegebenenfalls substituierte Amino-, Amid-, Alkylcarbonyl, gegebenenfalls substituierte Anilino-, Aldehyd-, Keto-, Carboxyl-, Hydroxyl-, Alkoxy-, Alkoxycarbonyl, Mercapto-, Cyano-, Hydroxyphenyl-, Carbonsäurealkylester-, Sulfonsäure-, Phosphorsäure-, Acryloxy-, Methacryloxy-, Glycidyloxy-, Epoxid-, Hydroxyl-oder Aminogruppen. Gruppe R ist bevorzugt ein (Meth) acryloxy-(C₁₋₆)-alkylen-Rest wie z. B. (Meth) acryloxypropyl. Konkrete Beispiele für Silane sind Vinyltriethoxysilan, Vinyltrimethoxysilan, Methacryloxypropyltrimethoxysilan (MPTS), Methacryloxypropyltriethoxysilan, Acryloxypropyltrimethoxysilan und Acryloxypropyltriethoxysilan, wobei MPTS mit Vorteil eingesetzt wird. Weitere Beispiele für Epoxysilane sind 3- Glycidyloxypropyltrimethoxysilan (GPTS) oder 3-Glycidyloxypropyltriethoxysilan.

In den vorstehenden Formeln können mehrmals vorhandene Reste R, R', X bzw. Y bei einer Verbindung jeweils die gleiche oder unterschiedliche Bedeutung haben. Es können auch Mischungen verschiedener hydrolysierbarer Silane verwendet werden.

Beispiele für anorganische Bindemittel sind Silicon-Lacke, die z. B. aus hydrolysierbaren Silanen hergestellt werden, die keine nicht-hydrolysierbaren Substituenten aufweisen, also z. B. Verbindungen der obigen Formel RₙSiX₄₋ₙ, worin n = 0 und X wie vorstehend definiert ist.

Bevorzugt weist die Zusammensetzung nur ein oder mehrere organisch modifizierte anorganische Bindemittel auf und keine organischen Bindemittel.

Bevorzugt sind Bindemittel, welche vernetzbare Gruppen enthalten, bevorzugt weist der nicht hydrolysierbare Rest mindestens eine funktionelle Gruppe auf, über die eine Vernetzung möglich ist. Abhängig von der Vernetzungsreaktion können noch entsprechende Initiatoren oder Katalysatoren zugesetzt werden. Als Katalysatoren/Initiatoren bzw. Vernetzungsinitiator kommen alle geläufigen und dem Fachmann bekannten Starter/Startsysteme in Frage, einschließlich radikalischer Photostarter, radikalischer Thermostarter, kationischer Photostarter, kationischer Thermostarter und beliebiger Kombinationen derselben.

Unter bestimmten Umständen kann ganz auf den Vernetzungsinitiator verzichtet werden, wie z. B. gegebenenfalls im Fall von Elektronenstrahl- oder Laserhärtung.

Konkrete Beispiele für einsetzbare radikalische Photostarter sind Irgacure ® 184 (1-Hydroxycyclohexylphenylketon),Irgacure ® 500 (1-Hydroxycyclohexylphenylketon, Benzophenon), Irgacure ® 819 (phosphine oxide, phenyl bis (2,4,6-trimethyl benzoyl) und andere von der Firma Ciba-Geigy erhältliche Photoinitiatoren vom Irgacure®-Typ, Darocure 1173, 1116, 1398, 1174 und 1020 (Fa. Merck), Benzophenon, 2-Chlorthioxanthon,2-Methylthioxanthon,2-Iso-propylthioxanthon, Benzoin, 4,4'-Dimethoxybenzoin, Benzoinethylether, Benzoinisopropylether, Benzildimethylketal, 1,1,1-Trichloracetophenon, Diethoxyacetophenon und Dibenzosuberon.

Beispiele für radikalische Thermostarter sind bevorzugt organische Peroxide in Form von Diacylperoxiden, Peroxydicarbonaten, Alkylperestern, Alkylperoxiden, Dialkylperoxiden, Perketalen, Ketonperoxiden und Alkylhydroperoxiden sowie Azo-Verbindungen. Als konkrete Beispiele wären hier insbesondere Dibenzoylperoxid, tert-Butylperbenzoat und Azoisobutyronitril zu nennen. Ein Beispiel für einen kationischen Photostarter ist Cyracure® UVI-6974, während ein bevorzugter kationischer Thermostarter 1-Methylimidazol ist.

Die Polykondensation induzierende Katalysatoren sind z. B. Brönsted-Säuren und -Basen, wie Mineralsäuren oder tertiäre Amine, für die anionische Polykondensation und Lewis-Säuren, wie Metallalkoholate (z. B. Aluminiumalkoholate im Falle von Epoxysilanen), für die kationische Polykondensation. Bei Beteiligung von Epoxidgruppen ist der Zusatz von Ringöffnungskatalysatoren wie beispielsweise N-Alkylimidazolen von besonderem Vorteil.

In einer bevorzugten Ausführungsform wird die hydrolysierbare Verbindung oder ein Sol der hydrolysierbaren Verbindung zu einem Sol enthaltend ITO-Nanopartikel, Bindemittel und evtl. Additive oder Initiatoren/Katalysatoren gegeben. Bevorzugt wird ein Sol des Bindemittels, im Falle von Silanen bevorzugt ein durch saure Katalyse erhaltenes Sol (oder Vorkondensat), zu einer Dispersion der ITO-Nanopartikel gegeben. Erst als letzte Komponente wird die hydrolysierbare Verbindung zugegeben.

Bevorzugt sind Bindemittel, welche durch Hitze oder Bestrahlung, bevorzugt von UV-Licht härten lassen. Bevorzugt ist das Bindemittel ein Hydrolysat von Silanen mit vernetzbaren Gruppen, bevorzugt Silane mit Epoxid-, Methacrylat- oder Acrylatgruppen, besonders bevorzugt ein MPTS-Hydrolysat.

Die Zusammensetzung wird danach einem Formgebungsprozess unterworfen. Dies beinhaltet die Herstellung von Beschichtungen, als auch das Einbringen in eine Form zur Herstellung von Formkörpern.

Im Falle von Formkörpern lassen sich über die dem Fachmann bekannten Formgebungsverfahren Formkörper herstellen. Beispielsweise seien Extrusion, Schlickerguss, Spritzgießen, Elektrophorese, Foliengießen Siebdruck oder Tiefdruck (Gravurdruck) genannt.

Es können dabei, je nach dem angewendeten Verfahren, auch Bindemittel eingesetzt werden. Als Bindemittel kommen z. B. die vorstehend genannten in Frage.

Als Formkörper können z. B. Schichten oder Sinterkörper, insbesondere Targets hergestellt werden. Targets werden insbesondere beim Sputter-Verfahren zur Beschichtung von Substraten eingesetzt. Ein besonderer Vorteil der erfindungsgemäßen Zusammensetzungen besteht darin, die erhaltenen Formkörper bei ähnlicher spezifischer Leitfähigkeit einen geringeren Indiumanteil aufweisen.

Formkörper finden als Bauteile oder Funktionskörper für leitfähige Systeme in der Opto- und Mikroelektronik oder als ITO-Quelle in Sputteranlagen Verwendung.

Bevorzugt ist die Herstellung von Beschichtungen durch Auftragen der Zusammensetzung auf ein Substrat. Die zur Beschichtung geeigneten Verfahren sind die herkömmlichen und dem Fachmann bekannten. Beispiele hierfür sind Tauchen, Sprühen, Rakeln, Streichen, Bürsten und Schleudern. Zur Beschichtung eignen sich Substrate aus beliebigen Materialien, wie z. B. Kunststoff, Metall, Glas, Halbleiter (z. B. Siliciumwafer) oder Keramik.

Im nächsten Schritt wird die Zusammensetzung gehärtet. Dies beinhaltet auch einfaches Trocknen der Zusammensetzung. Diese Temperaturbehandlung erfolgt bei Temperaturen zwischen 200 und 600 °C, bevorzugt bei Temperaturen zwischen 200 und 400 °C, besonders bevorzugt zwischen 210 und 260 °C.

Falls die Zusammensetzung vernetzbare Bestandteile, beispielsweise entsprechende Bindemittel, aufweist, kann die Härtung auch eine Behandlung unter Bedingungen, welche die Vernetzung hervorrufen, erfolgen. Bevorzugt ist eine Temperaturbehandlung oder Bestrahlung. Im Falle einer Bestrahlung ist eine Bestrahlung mit UV-Licht bevorzugt.

Es ist auch möglich, dass mehrere Behandlungen nacheinander oder gleichzeitig durch geführt werden. Bevorzugt ist, bei Verwendung eines entsprechenden Bindemittels, die Bestrahlung, bevorzugt mit UV-Licht, und nachfolgend eine Temperaturbehandlung bei Temperaturen zwischen 200 und 600 °C, wobei höhere Temperaturen eine weitere Verbesserung der Eigenschaften bewirken können. Dabei sind höhere Temperaturen zwischen 500 und 600 °C bevorzugt. Wie bereits erwähnt, zeichnen sich die durch das erfindungsgemäße Verfahren erhaltenen Beschichtungen durch einen verbesserten spezifischen Widerstand, bzw. spezifische Leitfähigkeit, aus, als Beschichtungen aus reinem ITO bei Verwendung von Beschichtungsdispersionen mit gleichen Gehalt an ITO (Gew.-%). Die so erhaltenen Schichten haben im Vergleich zu reinen ITO Schichten einen geringeren Anteil an ITO im Feststoffanteil und trotzdem einen verbesserten spezifischen Widerstand. Wobei verbessert bedeutet, dass der spezifische Widerstand der erfindungsgemäßen Schicht um über 20 %, bevorzugt über 30 % geringer ist. Das bedeutet, dass mit Schichten mit geringerem Feststoffgehalt an ITO, ein verbesserter spezifischer Widerstand erreicht werden kann und dadurch ITO eingespart werden kann. Dadurch sind die Schichten bei besserer Leitfähigkeit deutlich günstiger herzustellen. Ohne an eine bestimmte Theorie gebunden zu sein, könnte es sein, dass die Zugabe der hydrolysierbaren Verbindung den Ladungstransport zwischen den ITO-Nanopartikeln erleichtert und daher zu einer Verbesserung der Leitfähigkeit beiträgt. Dies scheint jedoch nur in einem bestimmten Anteil der Fall zu sein.

Gleichzeitig weisen die erfindungsgemäßen Beschichtungen auch die optische Qualität der entsprechenden ITO-Schichten. So zeigen sie eine ähnliche Transmission, Trübung oder Klarheit wie analog hergestellte Beschichtungen aus ITO. Lediglich bei hohen Anteilen der hydrolysierbaren Verbindung können die Werte etwas geringer sein. Da die Leitfähigkeit der erhaltenen ITO-Schichten und Formkörper im Vordergrund steht, weisen die erhaltenen Beschichtungen und Formkörper zwar im Vergleich zu den entsprechenden ITO-Schichten ähnlich gute optische Qualitäten auf, aber selbst die ITO-Schichten erreichen nicht die beispielsweise in US 5,518,810 beschriebenen IR-cutoff-Eigenschaften von größer 90% für Wellenlängen über 700 nm. So werden die in der US 5,518,810 verwendeten ITO-Partikel unter inerter Atmosphäre, Druck und bei höheren Temperaturen hergestellt.

Die erhaltenen Schichten zeigen auch bei geringer Schichtdicke eine gute Leitfähigkeit (spezifischer Widerstand von unter 10 Ωcm sogar unter 2 Ωcm oder 1 Ωcm nach Temperaturbehandlung). Durch den geringeren Gehalt an ITO sind sie deutlich kostengünstiger herzustellen.

Die Zugabe von entsprechenden Nanopartikeln anstatt einer hydrolysierbaren Verbindung führte zu keiner Verbesserung der Eigenschaften der erhaltenen Formkörper oder Beschichtungen.

Desweiteren betrifft die Erfindung auch mit dem erfindungsgemäßen Verfahren hergestellte Beschichtungen oder Formkörper.

Die erfindungsgemäß hergestellten Zusammensetzungen finden bevorzugt als Beschichtungsmaterial in der Opto- und Mikroelektronik oder für optische (transparente), IR-blockierende oder leitfähige Beschichtungen Verwendung.

Außerdem können sie für Siebdruckpasten oder Tiefdruckpasten verwendet werden. Sie können beispielsweise bevorzugt eingesetzt werden für transparente Ansteuerelektroden für Flüssigkeitsdisplays, Dünnfilmelektrolumineszenz-Displays, organische Photodioden, Elektrochromie-Displays, transparente leitfähige Schichten für hochempfindliche Strahlungs-selektoren, ferroelektrische Photoleiter, Speicheranordnungen, transparente leitfähige Oxidfilme als Gate-elektroden für Ladungs-, Injektions- und ladungsgekoppelte Anordnungen, sowie zur Herstellung von Druckpasten, die sich für die Bedruckung von Glas, Keramik und Kunststoffen eignen, zur Abschirmung von elektromagnetischen Wellen, für IR-reflektierenden Schichten bzw. Kunststoffe, leitfähige Elektroden für Solarzellen oder antistatische Filme, z. B. für Fernsehröhren, Monitore und Kontaktbildschirme. Die Beschichtungen können zur IR-Blockierung und zur Antistatikausrüstung verwendet werden. Die IR- Blockierung kann z. B. durch IR-Absorption oder durch IR-Reflektion erfolgen.

Weitere Einsatzmöglichkeiten ist die Verwendung für Plastikverscheibungen, IR-Sperren für Projektoren, IR-Sperren nach Lampen, IR-absorbierende Anstriche und Lacke, Wärmeschutzscheiben B. als Beschichtung von Glasscheiben für Backöfen), Sonnenkollektoren, Schichten auf Wärmetauschern, sowie transparente Wärmestrahlenabsorber auf Metallen, Glas, Keramiken und Kunststoffen, wie Anti(be)taubeschichtungen und heizbare Beschichtungen auf allen Substraten und Gegenständen (z. B. Fahrzeuge, Fenster, Fassaden, Instrumente, Verkehrsschilder, Hinweisschilder und Fenster von Kühlanlagen).

Desweiteren betrifft die Erfindung auch Artikel, welche erfindungsgemäße Beschichtungen enthalten, sowie die Verwendung dieser Artikel in den vorstehend genannten Anwendungen.

Die folgenden Beispiele erläutern die Erfindung, ohne sie zu beschränken.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.

### Ausführungsbeispiele:

### Herstellung der Sole

Es wurde eine Dispersion von ITO-Partikeln (vorzugsweise hergestellt nach WO 00/14017), vorhydrolysiertem 3-Methacryloxypropyltrimethoxysilan (MPTS) (Die Vorhydrolyse von MPTS wird mit verdünnter Salzsäure (0.1 mol/1) im Verhältnis MPTS:H₂O = 1:2 durchgeführt (24 h bei 40 °C) und anschließend das Methanol und Wasser bei 40 °C und Unterdruck (10 mbar) abdestilliert. Das so erhaltene MPTS-Vorhydrolysat ist zähflüssig und kann im Kühlschrank längere Zeit (ca. 1 Jahr) ohne Veränderung gelagert werden.), Photostarter (bevorzugt Irgacure 819, Irgacure 184) und einem alkoholischen Lösungsmittel (bevorzugt 1-Propanol oder Ethanol, auch möglich: Isopropoxyethanol mit einem Zusatz von Wasser) hergestellt. Zu dieser Dispersion wurde Tetraisopropylorthotitanat entsprechend der gewünschten Gew.-% an TiO₂ gegeben, wobei die Angabe in Gew.% TiO₂ auf den ITO Gehalt bezogen ist. Die Reihenfolge wurde in der oben beschriebenen Reihenfolge angewendet. Die Reihenfolge der Zugabe ist nicht von großer Bedeutung, doch sollte vorzugsweise das Tetraisopropylorthotitanat als letztes Edukt zugegeben werden.

Die Dispersion wurde bei Raumtemperatur gerührt (ca.15 min bis 24 h, vorzugsweise 1 h bis 18 h, besonders bevorzugt 2 bis 6 h) und anschließend zur Beschichtung verwendet. Zur längeren Aufbewahrung der Dispersion über mehrere Tage bis Wochen sollte die Lagerung im Kühlschrank erfolgen.

Die hergestellten Zusammensetzungen zeigen die Tabellen 1, 1a und 1b.

### Herstellung von Beschichtungen

Mit den hergestellten Zusammensetzungen wurden Substrate (vorzugsweise Glas, z.B. Borosilikatglas) mit Hilfe von spin-coating (Spin Coater Convac 1001) beschichtet. Tabelle 2 zeigt die bei unterschiedlichen Bedingungen hergestellten Beschichtungen. Darüber hinaus ist auch die Beschichtung von Kunststofffolien wie z.B. PET und PEN Folien, mittels Tiefdruck (bzw. Gravurdruck)(Labratester N.Schläfli Maschinen, Schweiz) möglich.

Die hergestellten Schichten wurden durch Bestrahlung mit UV-Licht gehärtet (Die bevorzugte Bestrahlungsenergie liegt dabei zwischen ca. 7 und 70 J/cm², was mit 1 bis 10 Durchläufen auf einem Fließband mit der Geschwindigkeit 1 m/min in einem UV-Belichtungsgerät UV-IR-Trockner (Typ UV-IR-Labortrockner, BE 25/120W/II+2, Firma Beltron) entspricht. Die in den Beispielen verwendete Bestrahlungsenergie betrug 70 J/cm², gemessen mit einem UV-Integrator der Firma Beltron) was 10 Durchläufen entspricht. Die Lichtenergie, gemessen mit dem UV-Integrator der Firma Beltron beträgt pro Durchlauf mit der Bandgeschwindigkeit 1 m/min ca. 7 J/cm².

Im Falle einer thermischen Behandlung wurden die beschichteten Substrate in einem Ofen bevorzugt einem Umluftofen bei 240 °C bzw. 550 °C zwischen 30 Minuten und 2 h, bevorzugt 30 min bis 1 h gesintert. Die Aufheizrate betrug 2,5 K/min, die Endtemperatur wurde 1 h aufrechterhalten, das Abkühlen der Proben erfolgte im Ofen ohne aktive Kühlung (Umluft ohne Heizen). Die thermische Behandlung wurde ohne Schutzgas unter Luft durchgeführt. Auch ein kürzeres Ausheizen im einem bereits vorgeheizten Ofen ist möglich. Durch die Verwendung von Schutzgas oder reduzierenden Gasen (z.B. Formiergas) kann der spezifische Widerstand der Schichten noch weiter gesenkt werden.

Von den erhaltenen Beschichtungen wurde der Schichtwiderstand mit einem Vierpunkt-Messgerät (Model RT-70, RG-7S, Napson Corporation) gemessen. Die Schichtdicke sowie der Brechungsindex wurde mit einem Spektral-Ellipsometer (Spectroscopic Ellipsometer, ESM-300, J.A. Woollam Co., Inc) bestimmt, wobei für verschiedene Sintertemperaturen unterschiedliche Fitting Modelle zur Bestimmung der Schichtdicke ausgewählt wurden (Fitting Modell EMA für Temperaturen bis 250 °C und Cauchy für Sintertemperatur 550 °C).

Zusätzlich wurde von den erhaltenen Beschichtungen nach der entsprechenden UV- bzw. kombinierten UV- und thermischen Behandlung Transmission, Haze (Trübung) und Clarity in Anlehnung an ASTM D1003 bestimmt bei Raumtemperatur (Haze-Gard plus, BYK Gardner). Von ausgewählten Proben wurden Transmissionsspektren gemessen (Cary 5000 UV-VIS-NIR Spektrophotometer, Varian).

Die Proben und die gemessenen Daten sind in folgenden Tabellen aufgeführt:
- Tabelle 1:: Hergestellte Zusammensetzungen der Beschichtungsdispersionen für Beschichtungen;
- Tabelle 1a:: Beispiel für eine zusammebsetzung nach ITS 10 ;
- Tabelle 1b:: Beispiel für eine Zusammensetzung nach ITO 20;
- Tabelle 1c:: Anorganische Bestandteile der fertigen Schicht;
- Tabelle 2:: Aufstellung der hergestellten Proben. Die mit * gekennzeichneten Proben wurden 1h gerührt. Dabei kam es zu Ausfällungen;
- Tabelle 3:: Widerstand gemessen 5 Minuten nach 10 UV-Behandlungen mit 1 m/min; Ellipsometrie-Modell zur Bestimmung der Schichtdicke: EMA);
- Tabelle 4:: Gemessene Eigenschaften einiger Proben nach einer Temperaturbehandlung bei 240 °C nach dem Abkühlen; (Fitting Modell bei Schichtdickenbestimmung: EMA) ;
- Tabelle 5:: Eigenschaften einiger Proben nach einer Temperaturbehandlung bei 550 °C nach dem Abkühlen; (Fitting Modell bei Schichtdickenbestimmung: Cauchy);
- Tabelle 6:: Schichtwiderstände, spez. Widerstände und spez. Leitfähigkeit 22 h nach der letzten UV-Behandlung und ggf. zusätzlicher thermischer Nachbehandlung von den Beschichtungen bei 240 °C bzw. 550 °C (jeweils 1 h); Die Lagerung erfolgte in einem klimatisierten Raum (20 °C, ca. 34 % Luftfeuchte) in geschlossenen Boxen zur Probenaufbewahrung.
- Tabelle 7:: Schichtwiderstände, spez. Widerstände und spez. Leitfähigkeit der Proben nach 84 Stunden; die Lagerung erfolgte in einem klimatisierten Raum (20 °C, ca. 34 % Luftfeuchte) in geschlossenen Boxen zur Probenaufbewahrung.
- Tabelle 8:: Schichtwiderstände, spez. Widerstände und spez. Leitfähigkeit der Proben nach einer Woche; die Lagerung erfolgte wie für Tabelle 7 beschrieben.
- Tabelle 9:: Schichtwiderstände, spez. Widerstände und spez. Leitfähigkeit der Proben nach zwei Wochen; die Lagerung erfolgte wie für Tablelle 7 beschrieben.
- Tabelle 10:: Schichtwiderstände, spez. Widerstände und spez. Leitfähigkeit der Proben nach drei Wochen; die Lagerung erfolgte wie für Tabelle 7 beschrieben.
- Tabelle 11:: Schichtwiderstände, spez. Widerstände und spez. Leitfähigkeit der Proben nach vier Wochen; die Lagerung erfolgte wie für Tabelle 7 beschrieben.
- Tabelle 12:: Transmission Haze und Clarity Messung (Byk Gardner (jeweils in %).

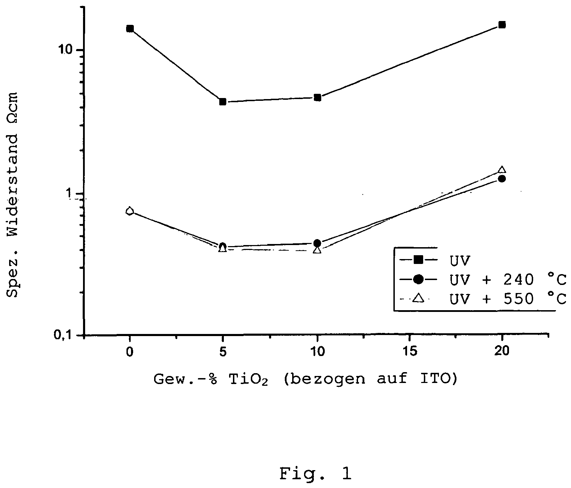

- Fig. 1:: Spezifischer Widerstand der bei 2000 rpm hergestellten Proben nach unterschiedlichen Temperaturbehandlungen nach der UV-Belichtung, aufgetragen gegen den Gehalt an TiO₂ in der Beschichtungsdispersion von 0 bis 20 Gew.-% (bezogen auf den ITO-Gehalt) Der ITO Gehalt der Beschichtungsdispersionen war konstant mit 20 Gew.-%)

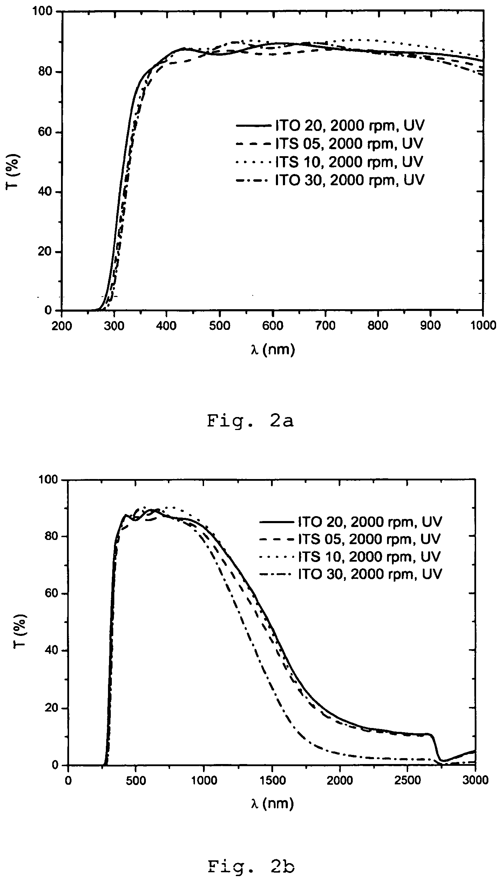

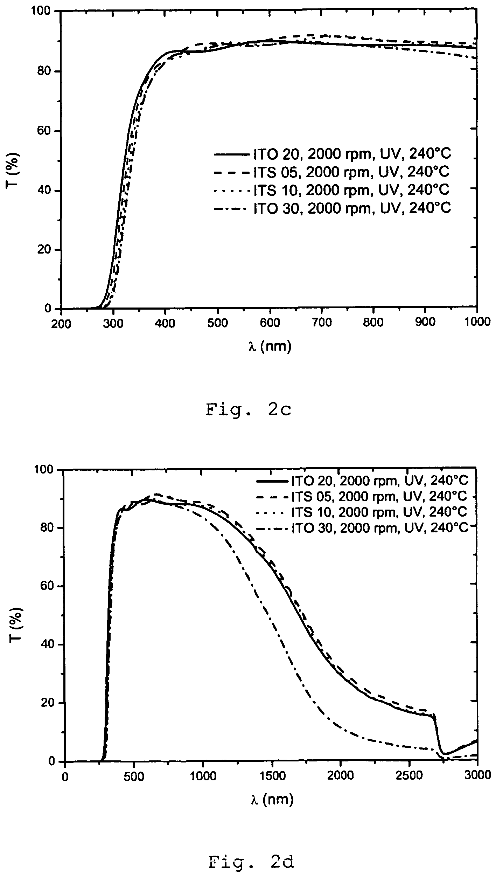

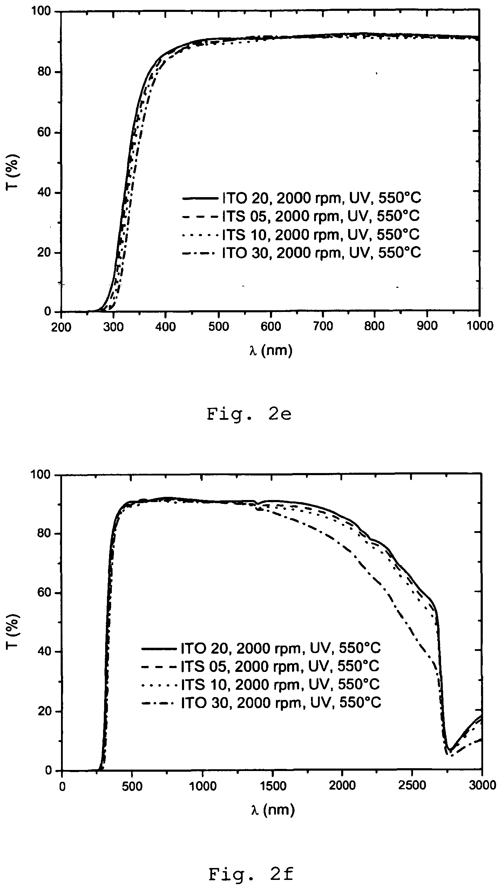

- Fig. 2a-f: Transmissionsspektren im UV-VIS- (Fig. 2a, 2c, 2e) und im UV-VIS-NIR-Bereich (Fig. 2b, 2d, 2f, λ: Wellenlänge) von ITO- und ITO-TiO₂-Schichten. Die ITO-Schichten ITO 20 und ITO 30 wurden mit 20 gew.-%iger bzw. 30 gew.-%iger ITO Beschichtungsdispersion hergestellt, die ITO-TiO₂-Schichten ITS 05 und· ITS 10 mit einer 20%igen ITO Dispersion mit 5 Gew.-% bzw. 10 Gew.-% Gehalt an Titanverbindung (berechnet als TiO₂ und bezogen auf ITO Gehalt in Gew.-%, siehe Tabellen 1, 1a, 1b). Alle Schichten wurden mittels Schleuderbeschichtung mit 2000 rpm hergestellt. Die Härtung der Schichten erfolgte mittels UV-Belichtung ohne weitere Temperaturbehandlung (Fig. 2a, b: Proben 18, 22, 2, 6; vgl. Tabelle 2) oder mittels UV-Belichtung und anschließender Temperaturbehandlung bei 240 °C (Fig. 2c, d: Proben 19, 23, 3, 7) bzw. 550 °C (Fig. 2e, f: Proben 20, 24, 4, 8).

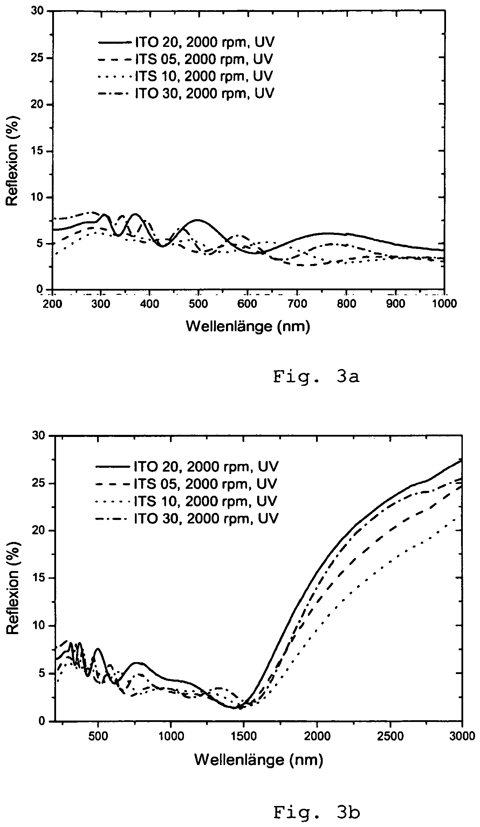

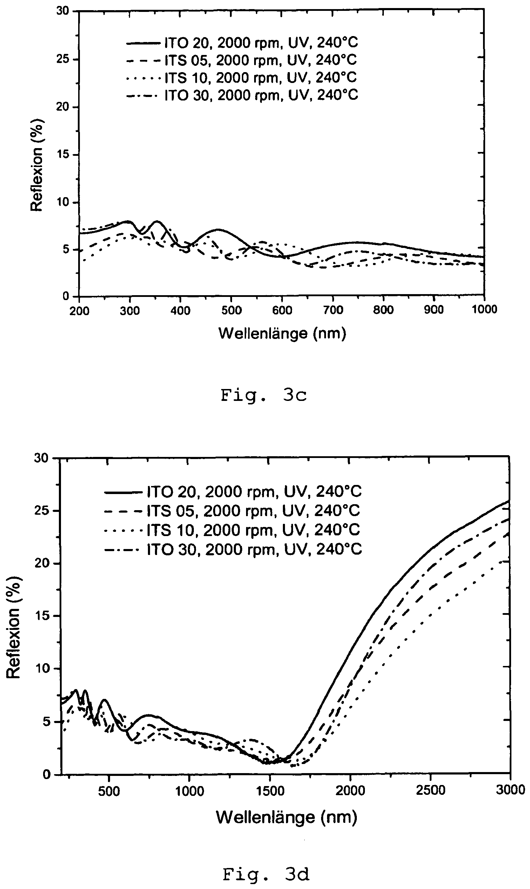

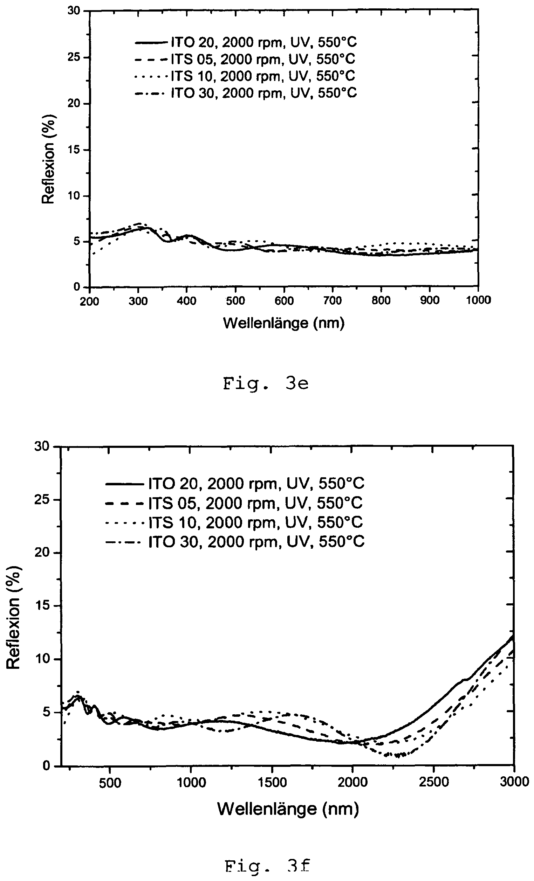

- Fig. 3a-f: Fig. 3a bis Fig. 3e zeigen Reflexionsspektren im UV-VIS- (Fig. 3a, 3c, 3e) und im UV-VIS-NIR-Bereich (Fig. 3b, 3d, 3f) der ITO- und ITO-TiO2-Schichten, deren Transmissionspektren in Fig. 2a bis Fig. 2e gezeigt sind (Beschreibung der Proben siehe Fig. 2a bis 2e).

Für die beschriebenen Versuche und Ergebnisse der ITO Schichten mit verschiedenen TiO₂ Gehalten (Tabellen 1 bis 12 und Fig. 1 bis 2) wurde der Gehalt an ITO in der Beschichtungsdispersion konstant gehalten (20 Gew.-%), ebenso der Gehalt an MPTSbasiertem Binder und Photostarter, lediglich der Gehalt an der Titanverbindung, die zur Bildung von TiO₂ in der Schicht führt (Tetraisopropyl-orthotitanat), wurde von 5 Gew.-% (berechnet als TiO₂ und bezogen auf ITO Gehalt in Gew.-%) auf bis zu 30 Gew.-% erhöht. Durch Erhöhen des TiO₂ Gehalts (Gew.-% bezogen auf ITO) in der Schicht nimmt der prozentuale Anteil an ITO (in Gew.-%) in der Schicht ab (siehe Tabelle 1, 1a und 1b).

In Tabelle 1c ist der Gehalt der anorganischen Bestandteile der erhaltenen Schichten angeführt. Die Schichten der Zusammensetzung mit TiO₂ einen deutlich geringeren Gehalt an ITO aufweisen. Der Gehalt an Bindemittel liegt bei unter 10 Gew.-% bezogen auf das Oxid SiO₂.

Tabelle 3 zeigt die gemessenen Eigenschaften der Beschichtungen nach 10 UV-Behandlungen (1 m/min). Bei den Proben ist eine deutliche Abnahme des spezifischen Widerstands bei Zunahme des Gehalts an TiO₂ auf 10 Gew.-% (ITS 10) im Vergleich zu einer Beschichtung mit gleichem Gehalt an ITO (ITO 20) in der Beschichtungsdispersion. Bei weiterer Zunahme des Gehalts an TiO₂ steigt der spezifische Widerstand wieder an.

Durch eine thermische Nachbehandlung nimmt der spezifische Widerstand aller Proben deutlich ab. Die Daten zu einer thermischen Nachbehandlung bei 240 °C, bzw. 550 °C sind in den Tabellen 4 und 5 angegeben. Erneut nimmt der spezifische Widerstand mit steigendem Gehalt an TiO₂ zuerst ab, um dann bei höheren Werten wieder anzusteigen. Für die bei 240 °C behandelten Proben wurde dabei ein Minimum von 10 Gew.-% festgestellt. Proben, welche bei 550 °C behandelt wurden zeigten sehr ähnliche Werte für 5 und 10 Gew.-%.

Auch bei einer Messung 22 h nach der UV-Behandlung zeigen alle Proben die gleiche Tendenz. (Messung des Widerstands 22 h nach der letzten Bestrahlung; Tabelle 6). Die erhaltenen spezifischen Widerstände einiger Proben (2, 3, 4, 6, 7, 8, 10, 11, 12, 18, 19, 20) sind in Fig. 1 in Abhängigkeit mit dem Gehalt an TiO₂ dargestellt.

Zusätzlich wurde das Alterungsverhalten der Beschichtungen bei einer Lagerung an Luft bei Raumtemperatur untersucht. Die Lagerung erfolgte in einem klimatisierten Raum (20 °C, ca. 34 % Luftfeuchte) in geschlossenen Boxen zur Probenaufbewahrung. In den Tabellen 7, 8, 9 und 10 sind die erhaltenen Messwerte nach 84 Stunden, 1 Woche, 2 Wochen, 3 Wochen und 4 Wochen angegeben. Die Messungen zeigen, dass auch nach 4 Wochen der bereits beschriebene Trend erhalten bleibt.

Zur Bestimmung der optischen Eigenschaften der Proben wurde die Transmission, Haze und Clarity gemessen (Tabelle 12). Die Messungen zeigen, dass die erfindungsgemäßen Beschichtungen, insbesondere ITS 05 und ITS 10, im Vergleich mit reinen ITO-Schichten gleichwertige optische Eigenschaften aufweisen. Eine thermische Nachbehandlung kann die Eigenschaften noch weiter verbessern.

Fig. 2a bis Fig. 2e zeigen Transmissionsspektren im UV-VIS-(Fig. 2a, 2c, 2e) und im UV-VIS-NIR-Bereich (Fig. 2b, 2d, 2f) von ITO- und ITO-TiO₂-Schichten. Die ITO-Schichten ITO 20 und ITO 30 wurden mit 20 Gew.-%iger bzw. 30 Gew.-%iger ITO Beschichtungsdispersion hergestellt (siehe Tabellen 1, 1a, 1b), die ITO-TiO₂-Schichten ITS 05 und ITS 10 mit einer 20%-igen ITO Dispersion mit 5 Gew.-% bzw. 10 Gew.-% Gehalt an Titanverbindung (berechnet als TiO₂ und bezogen auf ITO Gehalt in Gew.-%, siehe Tabelle 1a). Alle Schichten wurden mittels Schleuderbeschichtung mit 2000 rpm hergestellt. Die Härtung der Schichten erfolgte mittels UV-Belichtung entweder ohne weitere Temperaturbehandlung (Fig. 2a,b: Proben 18, 22, 2, 6; vgl. Tabelle 2) oder mittels UV-Belichtung und anschließender Temperaturbehandlung bei 240 °C (Fig. 2c,d: Proben 19, 23, 3, 7) bzw. 550 °C (Fig. 2e,f: Proben 20, 24, 4, 8). Es ist deutlich zu erkennen, dass die erfindungsgemäßen Proben trotz geringerem Gehalt an ITO mindestens gleichwertig zu den Proben aus reinem ITO sind.

Fig. 3a bis Fig. 3e zeigen Reflexionsspektren im UV-VIS- (Fig. 3a, 3c, 3e) und im UV-VIS-NIR-Bereich (Fig. 3b, 3d, 3f) der ITO- und ITO-TiO2-Schichten, deren Transmissionspektren in Fig. 2a bis Fig. 2e gezeigt sind (Beschreibung der Proben siehe Fig. 2a bis 2e).
Es ist deutlich zu erkennen, dass die Reflexion im sichtbaren Bereich durch den Gehalt an TiO₂. kaum beeinflusst wird
Die Reflexion im NIR-Bereich (Wellenlänge > 1500 nm) ist für UV-gehärtete Proben (Fig. 3a, 3b) und für UV-gehärtete Proben mit zusätzlicher Temperaturbehandlung bei 240°C (Fig. 3c, 3d) für ITO-TiO₂-Schichten geringer als für ITO Schichten ohne Zusatz von TiO₂. Die Reflexion im NIR-Bereich (Wellenlänge > 1500 nm) nimmt mit zunehmendem Gehalt an TiO₂ in der Schicht ab. Mit steigender Temperatur wird der Anstieg der Reflexion im NIR-Bereich zu sogar größeren Wellenlängen verschoben. So findet bei Proben die nach UV-Behandlung bei 550°C ausgeheizt wurden (Fig. 3e, 3f) der Anstieg der Reflexion erst bei Wellenlängen über 2500 nm statt. Es ist zu erkennen, dass für Wellenlängen über 2600 nm bzw. 2700 nm die Reflexion der ITO-TiO₂ Schichten ebenfalls kleiner ist als die Reflexion der reinen ITO Schichten. Auch hier nimmt die Reflexion im NIR-Bereich (Wellenlänge > 2700 nm) mit zunehmendem Gehalt an TiO₂ in der Schicht geringfügig ab.

### Liste der zitierten Literatur:

WO 00/14017
US 5,518,810

**Tabelle 1**

| Zusammensetzung der Beschichtungsdispersion | Gew.-% ITO | Gew.-% TiO₂ bezogen auf ITO Gehalt |
|---|---|---|
| ITS 05 | 20 | 5 |
| ITS 10 | 20 | 10 |
| ITS 20 | 20 | 20 |
| ITS 30 | 20 | 30 |
| ITO 20 (Vergleichsbeispiel) | 20 | 0 |
| ITO 30 (Vergleichsbeispiel) | 30 | 0 |
| ITO 40 (Vergleichsbeispiel) | 40 | 0 |

**Tabelle 1a**

| | **ITS 10** | **Gehalt in Schicht (g)** | **Gehalt in Schicht (Gew.-%)** |
|---|---|---|---|
| ITO Paste (61,01%) | 1,9669 g | 1,2 g ITO in Dispersion (und in Schicht) | 84,9 (ITO) |
| MPTS Vorhydrolysat | 0,3 g | 0,094 g SiO₂ | 6,6 (SiO₂) |
| Irgacure 819 | 0,015 g | | |
| Tetraisopropylorthotitanat | 0,4269 g | 0, 12 g TiO₂ | 8,5 (TiO₂) |
| 1-Propanol | 3,2912 g | | |
| Summe | 6 g | 1,414 g | 100 |
| TiO₂/ITO (Gew.) Schicht | 0,10 | 0,10 | 0,10 |

**Tabelle 1b**

| | **ITO 20** | **Gehalt in Schicht (g)** | **Gehalt in Schicht (Fest stoffanteil in Gew. -%)** |
|---|---|---|---|
| ITO Paste (61,01%) | 1,9669 g (= 1.2 g ITO, 20 Gew.-%) | 1,2 g ITO in Dispersion (und in Schicht) | 92,7 (ITO) |
| MPTS Vorhydrolysat | 0,3 g | 0,094 g SiO₂ | 7,3 (SiO₂) |
| Irgacure 819 | 0,015 g | | |
| 1-Propanol | 3,7181 g | | |
| Summe | 6 g | 1,294 g | 100 |

**Tabelle 1c**

| Gehalt in der gehärteten Schicht (anorganische Bestandteile) (Gew.-%, gerundet) | ITO | SiO₂ | TiO₂ |
|---|---|---|---|
| ITS 05 | 88.6 | 6.9 | 4.4 |
| ITS 10 | 84.9 | 6.7 | 8.5 |
| ITS 20 | 78,2 | 6.1 | 15.7 |
| ITS 30 | 72.6 | 5.7 | 21.8 |
| ITO 20 (Vergleichsbeispiel) | 92.7 | 7.3 | |
| ITO 30 (Vergleichsbeispiel) | 95.0 | 5.0 | |
| ITO 40 (Vergleichsbeispiel) | 96.2 | 3.8 | |

**Tabelle 2**

| Nr. | Beschichtung | Geschwindigkeit beim spin-coating (rpm) |
|---|---|---|
| **1** | ITS 05 | 1000 |
| **2** | ITS 05 | 2000 |
| **3** | ITS 05 | 2000 |
| **4** | ITS 05 | 2000 |
| **5** | ITS 10 | 1000 |
| **6** | ITS 10 | 2000 |
| **7** | ITS 10 | 2000 |
| **8** | ITS 10 | 2000 |
| **9** | ITS 20 | 1000 |
| **10** | ITS 20 | 2000 |
| **11** | ITS 20 | 2000 |
| **12** | ITS 20 | 2000 |
| **13** | ITS 30* | 1000 |
| **14** | ITS 30* | 2000 |
| **15** | ITS 30* | 2000 |
| **16** | ITS 30* | 2000 |
| **17** | ITO 20 | 1000 |
| **18** | ITO 20 | 2000 |
| **19** | ITO 20 | 2000 |
| **20** | ITO 20 | 2000 |
| **21** | ITO 30 | 1000 |
| **22** | ITO 30 | 2000 |
| **23** | ITO 30 | 2000 |
| **24** | ITO 30 | 2000 |
| **25** | ITO 40 | 1000 |
| **26** | ITO 40 | 2000 |
| **27** | ITO 40 | 2000 |
| **28** | ITO 40 | 2000 |

**Tabelle 3**

| *No.* | *Geschw.* (*spin coating*) | Schicht widerstand R/sq | *Standardab weichung* | Schichtdicke | spez. Widerstand | spez. Leitfähigkeit | Brechungs index |
|---|---|---|---|---|---|---|---|
| | *rpm* | kΩ/sq | *kΩ*/*sq* | nm | Ωcm | S/cm | |
| **ITS 05** | | | | | | | |
| **1** | 1000 | 30,2 | *0,59* | 693 | 2,09 | 0,478 | 1,5241 |
| **2** | 2000 | 38,2 | *0,65* | 441 | 1,68 | 0,594 | 1,6119 |
| **3** | 2000 | 35,8 | *0,88* | | | | |
| **4** | 2000 | 35,4 | *0,53* | | | | |
| **ITS 10** | | | | | | | |
| **5** | 1000 | 25,8 | *0,79* | 752 | 1,94 | 0,515 | 1,5895 |
| **6** | 2000 | 30,7 | *0,27* | 522 | 1,60 | 0,624 | 1,5997 |
| **7** | 2000 | 28,2 | *0,53* | | | | |
| **8** | 2000 | 28,4 | *0,38* | | | | |
| **ITS 20** | | | | | | | |
| **9** | 1000 | 42,8 | 2,16 | 1022 | 4,37 | 0,229 | 1,5844 |
| **10** | 2000 | 56,0 | *2,33* | 690 | 3,86 | 0,259 | 1,5823 |
| **11** | 2000 | 57,2 | *1,62* | | | | |
| **12** | 2000 | 59,1 | *1,75* | | | | |
| **ITS 30** | | | | | | | |
| **13** | 1000 | n.m. | *n.m.* | n.m. | n.m. | n.m. | n.m. |
| **14** | 2000 | 209,3 | *36,56* | 748 | 15,66 | 0,064 | 1,5446 |
| **15** | 2000 | 265,3 | *81,02* | | | | |
| **16** | 2000 | 262,5 | *48,21* | | | | |
| **ITO 20** | | | | | | | |
| **17** | 1000 | 183,8 | *4,33* | 589 | 10,82 | 0,092 | 1,6079 |
| **18** | 2000 | 158,3 | *35,84* | 383 | 6,06 | 0,165 | 1,6259 |
| **19** | 2000 | 128,1 | *14,68* | | | | |
| **20** | 2000 | 144,3 | *35,12* | | | | |
| **ITO 30** | | | | | | | |
| **21** | 1000 | 7,0 | *0,12* | 885 | 0,62 | 1,615 | 1,6299 |
| **22** | 2000 | 8,4 | *0,17* | 647 | 0,54 | 1,842 | 1,6141 |
| **23** | 2000 | 10,0 | *0,40* | | | | |
| **24** | 2000 | 8,8 | *0,42* | | | | |
| **ITO 40** | | | | | | | |
| **25** | 1000 | 4,1 | *0,12* | 1618 | 0,67 | 1,501 | 1,6339 |
| **26** | 2000 | 5,8 | *0,06* | 1191 | 0,69 | 1,444 | 1,6342 |
| **27** | 2000 | 6,3 | *0,32* | | | | |
| **28** | 2000 | 5,6 | *0,18* | | | | |

**Tabelle 4**

| Nr. | | Schichtwid erstand | Standard abweichung | Schicht dicke | Spez. Widerstand | Spez. Leitfähigkeit | Brechungsindex |
|---|---|---|---|---|---|---|---|
| | | kΩ/sq | kΩ/sq | nm | Ωcm | S/cm | |
| **3** | ITS 05 | 15,8 | *0,54* | 425 | 0,67 | 1,493 | 1,5915 |
| **7** | ITS 10 | 15,9 | *1,30* | 486 | 0,77 | 1,292 | 1,5748 |
| **11** | ITS 20 | 34,2 | *1,20* | 649 | 2,22 | 0,450 | 1,5561 |
| **15** | ITS 30 | 77,7 | *5,84* | 854 ? | 6,64 | 0,151 | 1.5917 |
| **19** | ITO 20 | 25,3 | *1,74* | 387 | 0,98 | 1,020 | 1,5859 |
| **23** | ITO 30 | 5,8 | *0,16* | 620 | 0,36 | 2,769 | 1,5817 |
| **27** | ITO 40 | 2,6 | *0,11* | 1152 | 0,30 | 3,377 | 1,5971 |

**Tabelle 5**

| Nr. | | Schich twider stand | Standard abweichung | Schichtdicke | Spez. Widerstand | Spez. Leitfähigkeit | Brechungsindex |
|---|---|---|---|---|---|---|---|
| | | kΩ/sq | kΩ/sq | nm | Ωcm | S/cm | |
| **4** | ITS 05 | 9,6 | *0,37* | 408 | 0,39 | 2,542 | 1,5131 |
| **8** | ITS 10 | 9,7 | *0,47* | 413 | 0,40 | 2,488 | 1,5653 |
| **12** | ITS 20 | 24,9 | *0,85* | 571 | 1,42 | 0,703 | 1,6014 |
| **16** | ITS 30 | 64,7 | *4,05* | n.m. | n.m | n.m. | n.m. |
| **20** | ITO 20 | 22,4 | *0,63* | 350 | 0,78 | 1,276 | 1,5004 |
| **24** | ITO 30 | 4,7 | *0,18* | 563 | 0,26 | 3,787 | 1,5167 |
| **28** | ITO 40 | 2,5 | *0,06* | 1048 | 0,26 | 3,848 | 1,5189 |

| | | | | | | | |
|---|---|---|---|---|---|---|---|
| n.m. : nicht gemessen. | | | | | | | |

**Tabelle 6**

| *Nr.* | | Thermische Behandlung | Schichtwiderstand (kQ/sq) | Standardabweichung | Schichtdicke (nm) | Brechungsindex | Spez. Widerstand Ωcm | Spez. Leitfähigkeit S/cm |
|---|---|---|---|---|---|---|---|---|
| **1** | ITS 05 | - | 79,8 | *0,5* | 693 | 1,5241 | 5,53 | 0,181 |
| **2** | ITS 05 | - | 98,7 | *1,6* | 441 | 1,6119 | 4,35 | 0,230 |
| **3** | ITS 05 | 240°C | 9,9 | *0,1* | 425 | 1,5915 | 0,42 | 2,382 |
| **4** | ITS 05 | 550°C | 9,7 | *0,6* | 408 | 1,5131 | 0,40 | 2,516 |
| **5** | ITS 10 | - | 76,5 | *1,6* | 752 | 1,5895 | 5,75 | 0,174 |
| **6** | ITS 10 | - | 88,8 | *1,5* | 522 | 1,5997 | 4,64 | 0,216 |
| **7** | ITS 10 | 240°C | 9,0 | *0,3* | 486 | 1,5748 | 0,44 | 2,292 |
| **8** | ITS 10 | 550°C | 9,4 | *0,4* | 413 | 1,5653 | 0,39 | 2,576 |
| **9** | ITS 20 | - | 168,1 | *2,6* | 1022 | 1,5844 | 17,18 | 0,058 |
| **10** | ITS 20 | - | 212,2 | *5,1* | 690 | 1,5823 | 14,64 | 0,068 |
| **11** | ITS 20 | 240°C | 19,1 | *0,5* | 649 | 1,5561 | 1,24 | 0,806 |
| **12** | ITS 20 | 550°C | 24, 9 | *1,6* | 571 | 1,6014 | 1,42 | 0,702 |
| **13** | ITS 30 | - | n.m. | n.m. | n.m. | n.m. | n.m. | n.m. |
| **14** | ITS 30 | - | 736,3 | *177,4* | 748 | 1,5446 | 55,08 | 0,018 |
| **15** | ITS 30 | 240°C | 47,7 | *2,7* | 854 ? | 15.917 | 4,07 | 0,246 |
| **16** | ITS 30 | 550°C | 66,4 | *8,1* | n.m. | n.m. | n.m. | n.m. |
| **17** | ITO 20 | - | 535,8 | *16,1* | 589 | 1,6079 | 31,56 | 0,032 |
| **18** | ITO 20 | - | 365,1 | *34,0* | 383 | 1,6259 | 13,98 | 0,072 |
| **19** | ITO 20 | 240°C | 19,0 | *0,3* | 387 | 1,5859 | 0,74 | 1,357 |
| **20** | ITO 20 | 550°C | 21,5 | *0,7* | 350 | 1,5004 | 0,75 | 1,330 |
| **21** | ITO 30 | - | 33,8 | *10,3* | 885 | 1,6299 | 2,99 | 0,335 |
| **22** | ITO 30 | - | 39,2 | *0,8* | 647 | 1,6141 | 2,53 | 0,395 |
| **23** | ITO 30 | 240°C | 4,9 | *0,1* | 620 | 1,5817 | 0,30 | 3,321 |

| *Nr.* | | Thermische Behandlung | Schichtwiderstand (kΩ/sq) | Standardabweichung | Schichtdicke (nm) | Brechungsindex | Spez. Widerstand Ωcm | Spez. Leitfähigkeit S/cm |
|---|---|---|---|---|---|---|---|---|
| **24** | ITO 30 | 550°C | 4,5 | *0,2* | 563 | 1,5167 | 0,25 | 3,947 |
| **25** | ITO 40 | - | 11,6 | *0,1* | 1618 | 1,6339 | 1,88 | 0,531 |
| **26** | ITO 40 | - | 19,8 | *0,5* | 1191 | 1,6342 | 2,36 | 0,424 |
| **27** | ITO 40 | 240°C | 2,1 | *0,1* | 1152 | 1,5971 | 0,24 | 4,099 |
| **28** | ITO 40 | 550°C | 2,5 | *0,0* | 1048 | 1,5189 | 0,26 | 3,877 |

| | | | | | | | | |
|---|---|---|---|---|---|---|---|---|
| n.m. : nicht gemessen. | | | | | | | | |

### Tabelle 6 (Fortsetzung)

**Tabelle 7**

| *Nr.* | | Thermische Behandlung | Schichtwiderstand (kΩ/sq) | Standardabweichung | Schichtdicke (nm) | Brechungsindex | Spez. Widerstand Ωcm | Spez. Leitfähigkeit S/cm |
|---|---|---|---|---|---|---|---|---|
| **1** | ITS 05 | - | 114,7 | 2,75 | 693 | 1,5241 | 7,95 | 0,126 |
| **2** | ITS 05 | - | 133,9 | 4,10 | 441 | 1,6119 | 5,90 | 0,169 |
| **3** | ITS 05 | 240°C | 10,1 | 0,16 | 425 | 1,5915 | 0,43 | 2,319 |
| **4** | ITS 05 | 550°C | 6,9 | 0,13 | 408 | 1,5131 | 0,28 | 3,560 |
| **5** | ITS 10 | - | 116,1 | 3,35 | 752 | 1,5895 | 8,73 | 0,114 |
| **6** | ITS 10 | - | 129,2 | 2,13 | 522 | 1,5997 | 6,75 | 0,148 |
| **7** | ITS 10 | 240°C | 9,2 | 0,08 | 486 | 1,5748 | 0,45 | 2,229 |
| **8** | ITS 10 | 550°C | 7,1 | 0,25 | 413 | 1,5653 | 0,29 | 3,407 |
| **9** | ITS 20 | - | 266,5 | 9,22 | 1022 | 1,5844 | 27,24 | 0,037 |
| **10** | ITS 20 | - | 315,5 | 11,92 | 690 | 1,5823 | 21,77 | 0,046 |
| **11** | ITS 20 | 240°C | 266,5 | 9,22 | 649 | 1,5561 | 17,30 | 0,058 |
| **12** | ITS 20 | 550°C | 19,3 | 1,06 | 571 | 1,6014 | 1,10 | 0,908 |
| **13** | ITS 30 | - | n.m. | n.m. | n.m. | n.m. | n.m. | n.m. |
| **14** | ITS 30 | - | 1339,0 | 500,60 | 748 | 1,5446 | 100,15 | 0,010 |
| **15** | ITS 30 | 240°C | 49,6 | 4,65 | 854 | 15.917 | 4,24 | 0,236 |
| **16** | ITS 30 | 550°C | 48,2 | 5,91 | n.m. | n.m. | n.m. | n.m. |
| **17** | ITO 20 | - | 530,7 | 14,54 | 589 | 1,6079 | 31,26 | 0,032 |
| **18** | ITO 20 | - | 377,6 | 19,67 | 383 | 1,6259 | 14,46 | 0,069 |
| **19** | ITO 20 | 240°C | 17,5 | 0,26 | 387 | 1,5859 | 0,68 | 1,481 |
| **20** | ITO 20 | 550°C | 14,7 | 0,70 | 350 | 1,5004 | 0,51 | 1,948 |
| **21** | ITO 30 | - | 41,6 | 5,95 | 885 | 1,6299 | 3,68 | 0,272 |
| **22** | ITO 30 | - | 51,2 | 1,49 | 647 | 1,6141 | 3,31 | 0,302 |
| **23** | ITO 30 | 240°C | 4,5 | 0,14 | 620 | 1,5817 | 0,28 | 3,554 |
| **24** | ITO 30 | 550°C | 3,5 | 0,17 | 563 | 1,5167 | 0,20 | 5,106 |
| **25** | ITO 40 | - | 15,2 | 0,50 | 1618 | 1,6339 | 2,45 | 0,407 |
| **26** | ITO 40 | - | 24,8 | 0,57 | 1191 | 1,6342 | 2,95 | 0,338 |
| **27** | ITO 40 | 240 °C | 2,1 | 0,05 | 1152 | 1,5971 | 0,24 | 4,148 |
| **28** | ITO 40 | 550 °C | 1,6 | 0,51 | 1048 | 1,5189 | 0,16 | 6,103 |

| | | | | | | | | |
|---|---|---|---|---|---|---|---|---|
| n.m. : nicht gemessen. | | | | | | | | |

### Tabelle 7 (Fortsetzung)

**Tabelle 8**

| *Nr.* | | Thermische Behandlung | Schichtwiderstand (kΩ/sq) | Standardabweichung | Schichtdicke (nm) | Brechungsindex | Spez. Widerstand Ωcm | Spez. Leitfähigkeit S/cm |
|---|---|---|---|---|---|---|---|---|
| **1** | ITS 05 | - | 170,1 | 1,24 | 693 | 1,5241 | 11,79 | 0,085 |
| **2** | ITS 05 | - | 235,3 | 5,35 | 441 | 1,6119 | 10,37 | 0,096 |
| **3** | ITS 05 | 240 °C | 16,6 | 0,25 | 425 | 1,5915 | 0,70 | 1,421 |
| **4** | ITS 05 | 550 °C | 7,0 | 0,15 | 408 | 1,5131 | 0,29 | 3,494 |
| **5** | ITS 10 | - | 183,5 | 2,34 | 752 | 1,5895 | 13,80 | 0,072 |
| **6** | ITS 10 | - | 227,0 | 5,63 | 522 | 1,5997 | 11,85 | 0,084 |
| **7** | ITS 10 | 240 °C | 11,7 | 0,19 | 486 | 1,5748 | 0,57 | 1,755 |
| **8** | ITS 10 | 550 °C | 7,6 | 0,15 | 413 | 1,5653 | 0,31 | 3,194 |
| **9** | ITS 20 | - | 424,0 | 11,27 | 1022 | 1,5844 | 43,33 | 0,023 |
| **10** | ITS 20 | - | 509,9 | 13,87 | 690 | 1,5823 | 35,18 | 0,028 |
| **11** | ITS 20 | 240 °C | 28,1 | 0,69 | 649 | 1,5561 | 1,82 | 0,548 |
| **12** | ITS 20 | 550 °C | 20,8 | 0,60 | 571 | 1,6014 | 1,19 | 0,843 |
| **13** | ITS 30 | - | n.m. | n.m. | n.m. | n.m. | n.m. | n.m. |
| **14** | ITS 30 | - | 1818,4 | 472,73 | 748 | 1,5446 | 136,02 | 0,007 |
| **15** | ITS 30 | 240 °C | 76,2 | 3,83 | 854 | 15.917 | 6,50 | 0,154 |
| **16** | ITS 30 | 550 °C | 53,0 | 2,65 | n.m. | n.m. | n.m. | n.m. |
| **17** | ITO 20 | - | 299,6 | 4,12 | 589 | 1,6079 | 17,65 | 0,057 |
| **18** | ITO 20 | - | 227,7 | 7,36 | 383 | 1,6259 | 8,72 | 0,115 |
| **19** | ITO 20 | 240 °C | 16,9 | 0,19 | 387 | 1,5859 | 0,66 | 1,526 |
| **20** | ITO 20 | 550 °C | 15,3 | 0,37 | 350 | 1,5004 | 0,54 | 1,868 |
| **21** | ITO 30 | - | 25,6 | 0,53 | 885 | 1,6299 | 2,27 | 0,441 |
| **22** | ITO 30 | - | 44,2 | 0,61 | 647 | 1,6141 | 2,86 | 0,349 |
| **23** | ITO 30 | 240 °C | 4,8 | 0,14 | 620 | 1,5817 | 0,30 | 3,374 |
| **24** | ITO 30 | 550 °C | 3,5 | 0,09 | 563 | 1,5167 | 0,19 | 5,132 |
| **25** | ITO 40 | - | 11,5 | 0,16 | 1618 | 1,6339 | 1,86 | 0,539 |
| **26** | ITO 40 | - | 18,4 | 0,56 | 1191 | 1,6342 | 2,19 | 0,457 |
| **27** | ITO 40 | 240 °C | 3,1 | 0,06 | 1152 | 1,5971 | 0,36 | 2,760 |
| **28** | ITO 40 | 550 °C | 1,6 | 0,06 | 1048 | 1,5189 | 0,17 | 5,826 |

| | | | | | | | | |
|---|---|---|---|---|---|---|---|---|
| n.m. : nicht gemessen. | | | | | | | | |

### Tabelle 8 (Fortsetzung)

**Tabelle 9**

| *Nr.* | | Thermische Behandlung | Schichtwiderstand (kΩ/sq) | Standardabweichung | Schichtdicke (nm) | Brechungsindex | Spez. Widerstand Ωcm | Spez. Leitfähigkeit S/cm |
|---|---|---|---|---|---|---|---|---|
| **1** | ITS 05 | - | 113,1 | 2,20 | 693 | 1,5241 | 7,84 | 0,128 |
| **2** | ITS 05 | - | 122,4 | 4,43 | 441 | 1,6119 | 5,40 | 0,185 |
| **3** | ITS 05 | 240°C | 11,4 | 0,18 | 425 | 1,5915 | 0,48 | 2,073 |
| **4** | ITS 05 | 550°C | 4,5 | 0,20 | 408 | 1,5131 | 0,18 | 5,492 |
| **5** | ITS 10 | - | 99,4 | 8,65 | 752 | 1,5895 | 7,47 | 0,134 |
| **6** | ITS 10 | - | 105,8 | 11,95 | 522 | 1,5997 | 5,52 | 0,181 |
| **7** | ITS 10 | 240°C | 10,4 | 0,67 | 486 | 1,5748 | 0,51 | 1,979 |
| **8** | ITS 10 | 550°C | 4,8 | 0,13 | 413 | 1,5653 | 0,20 | 5,087 |
| **9** | ITS 20 | - | 246,2 | 11,58 | 1022 | 1,5844 | 25,16 | 0,040 |
| **10** | ITS 20 | - | 280,5 | 46,04 | 690 | 1,5823 | 19,35 | 0,052 |
| **11** | ITS 20 | 240°C | 23,6 | 0,41 | 649 | 1,5561 | 1,53 | 0,653 |
| **12** | ITS 20 | 550°C | 12,8 | 0,41 | 571 | 1,6014 | 0,73 | 1,371 |
| **13** | ITS 30 | - | n.m. | n.m. | n.m. | n.m. | n.m. | n.m. |
| **14** | ITS 30 | - | 969,9 | 165,06 | 748 | 1,5446 | 72,55 | 0,014 |
| **15** | ITS 30 | 240°C | 61,6 | 4,76 | 854 | 15.917 | 5,26 | 0,190 |
| **16** | ITS 30 | 550°C | 36,8 | 2,62 | n.m. | n.m. | n.m. | n.m. |
| **17** | ITO 20 | - | 333,6 | 4,45 | 589 | 1,6079 | 19,65 | 0,051 |
| **18** | ITO 20 | - | 244,9 | 10,69 | 383 | 1,6259 | 9,38 | 0,107 |
| **19** | ITO 20 | 240°C | 16,7 | 0,51 | 387 | 1,5859 | 0,65 | 1,545 |
| **20** | ITO 20 | 550°C | 10,0 | 0,82 | 350 | 1,5004 | 0,35 | 2,860 |
| **21** | ITO 30 | - | 31,0 | 1,50 | 885 | 1,6299 | 2,74 | 0,365 |
| **22** | ITO 30 | - | 48,0 | 1,01 | 647 | 1,6141 | 3,11 | 0,322 |
| **23** | ITO 30 | 240°C | 4,8 | 0,12 | 620 | 1,5817 | 0,30 | 3,376 |
| **24** | ITO 30 | 550°C | 2,3 | 0,18 | 563 | 1,5167 | 0,13 | 7,583 |
| **25** | ITO 40 | - | 12,6 | 0,19 | 1618 | 1,6339 | 2,04 | 0,490 |
| **26** | ITO 40 | - | 21,0 | 0,29 | 1191 | 1,6342 | 2,50 | 0,400 |
| **27** | ITO 40 | 240°C | 3,0 | 0,11 | 1152 | 1,5971 | 0,34 | 2,924 |
| **28** | ITO 40 | 550°C | 1,2 | 0,05 | 1048 | 1,5189 | 0,12 | 8,234 |

| | | | | | | | | |
|---|---|---|---|---|---|---|---|---|
| n.m. : nicht gemessen. | | | | | | | | |

### Tabelle 9 (Fortsetzung)

**Tabelle 10**

| *Nr.* | | Thermische Behandlung | Schichtwiderstand (kΩ/sq) | Standardabweichung | Schichtdicke (nm) | Brechungsindex | Spez. Widerstand Ωcm | Spez. Leitfähigkeit S/cm |
|---|---|---|---|---|---|---|---|---|
| **1** | ITS 05 | - | 113,1 | 2,20 | 693 | 1,5241 | 7,84 | 0,128 |
| **2** | ITS 05 | - | 122,4 | 4,43 | 441 | 1,6119 | 5,40 | 0,185 |
| **3** | ITS 05 | 240 °C | 11,4 | 0,18 | 425 | 1,5915 | 0,48 | 2,073 |
| **4** | ITS 05 | 550°C | 4,5 | 0,20 | 408 | 1,5131 | 0,18 | 5,492 |
| **5** | ITS 10 | - | 99,4 | 8,65 | 752 | 1,5895 | 7,47 | 0,134 |
| **6** | ITS 10 | - | 105,8 | 11,95 | 522 | 1,5997 | 5,52 | 0,181 |
| **7** | ITS 10 | 240 °C | 10,4 | 0,67 | 486 | 1,5748 | 0,51 | 1,979 |
| **8** | ITS 10 | 550 °C | 4,8 | 0,13 | 413 | 1,5653 | 0,20 | 5,087 |
| **9** | ITS 20 | - | 246,2 | 11,58 | 1022 | 1,5844 | 25,16 | 0,040 |
| **10** | ITS 20 | - | 280,5 | 46,04 | 690 | 1,5823 | 19,35 | 0,052 |
| **11** | ITS 20 | 240 °C | 23,6 | 0,41 | 649 | 1,5561 | 1,53 | 0,653 |
| **12** | ITS 20 | 550 °C | 12,8 | 0,41 | 571 | 1,6014 | 0,73 | 1,371 |
| **13** | ITS 30 | - | n.m. | n.m. | n.m. | n.m. | n.m. | n.m. |
| **14** | ITS 30 | - | 969,9 | 165,06 | 748 | 1,5446 | 72,55 | 0,014 |
| **15** | ITS 30 | 240 °C | 61,6 | 4,76 | 854 | 15.917 | 5,26 | 0,190 |
| **16** | ITS 30 | 550°C | 36,8 | 2,62 | n.m. | n.m. | n.m. | n.m. |
| **17** | ITO 20 | - | 333,6 | 4,45 | 589 | 1,6079 | 19,65 | 0,051 |
| **18** | ITO 20 | - | 244,9 | 10,69 | 383 | 1,6259 | 9,38 | 0,107 |
| **19** | ITO 20 | 240 °C | 16,7 | 0,51 | 387 | 1,5859 | 0,65 | 1,545 |
| **20** | ITO 20 | 550 °C | 10,0 | 0,82 | 350 | 1,5004 | 0,35 | 2,860 |
| **21** | ITO 30 | - | 31,0 | 1,50 | 885 | 1,6299 | 2,74 | 0,365 |
| **22** | ITO 30 | - | 48,0 | 1,01 | 647 | 1,6141 | 3,11 | 0,322 |
| **23** | ITO 30 | 240 °C | 4,8 | 0,12 | 620 | 1,5817 | 0,30 | 3,376 |
| **24** | ITO 30 | 550 °C | 2,3 | 0,18 | 563 | 1,5167 | 0,13 | 7,583 |
| **25** | ITO 40 | - | 12,6 | 0,19 | 1618 | 1,6339 | 2,04 | 0,490 |
| **26** | ITO 40 | - | 21,0 | 0,29 | 1191 | 1,6342 | 2,50 | 0,400 |
| **27** | ITO 40 | 240 °C | 3,0 | 0,11 | 1152 | 1,5971 | 0,34 | 2,924 |
| **28** | ITO 40 | 550 °C | 1,2 | 0,05 | 1048 | 1,5189 | 0,12 | 8,234 |

| | | | | | | | | |
|---|---|---|---|---|---|---|---|---|
| n.m. : nicht gemessen. | | | | | | | | |

### Tabelle 10 (Fortsetzung)

**Tabelle 11**

| *Nr.* | | Thermische Behandlung | Schichtwiderstand (kΩ/sq) | Standardabweichung | Schichtdicke (nm) | Brechungsindex | Spez. Widerstand Ωcm | Spez. Leitfähigkeit S/cm |
|---|---|---|---|---|---|---|---|---|
| **1** | ITS 05 | - | 91,5 | 2,83 | 693 | 1,5241 | 6,34 | 0,158 |
| **2** | ITS 05 | - | 101,8 | 2,27 | 441 | 1,6119 | 4,49 | 0,223 |
| **3** | ITS 05 | 240 °C | 10,1 | 0,09 | 425 | 1,5915 | 0,43 | 2,329 |
| **4** | ITS 05 | 550 °C | 3,7 | 0,08 | 408 | 1,5131 | 0,15 | 6,565 |
| **5** | ITS 10 | - | 82,9 | 4,12 | 752 | 1,5895 | 6,23 | 0,160 |
| **6** | ITS 10 | - | 88,0 | 6,45 | 522 | 1,5997 | 4,59 | 0,218 |
| **7** | ITS 10 | 240 °C | 9,5 | 0,41 | 486 | 1,5748 | 0,46 | 2,159 |
| **8** | ITS 10 | 550 °C | 4,0 | 0,17 | 413 | 1,5653 | 0,17 | 6,040 |
| **9** | ITS 20 | - | 164,3 | 80,57 | 1022 | 1,5844 | 16,79 | 0,060 |
| **10** | ITS 20 | - | 222,0 | 7,42 | 690 | 1,5823 | 15,32 | 0,065 |
| **11** | ITS 20 | 240 °C | 21,3 | 0,24 | 649 | 1,5561 | 1,38 | 0,725 |
| **12** | ITS 20 | 550 °C | 11,5 | 0,74 | 571 | 1,6014 | 0,65 | 1,527 |
| **13** | ITS 30 | | n.m. | n.m. | n.m. | n.m. | n.m. | n.m. |
| **14** | ITS 30 | | 840,8 | 325,80 | 748 | 1,5446 | 62,89 | 0,016 |
| **15** | ITS 30 | 240 °C | 54,8 | 1,22 | 854 | 15.917 | 4,68 | 0,214 |
| **16** | ITS 30 | 550 °C | 32,2 | 2,97 | n.m. | n.m. | n.m. | n.m. |
| **17** | ITO 20 | - | 356,1 | 16,32 | 589 | 1,6079 | 20,98 | 0,048 |
| **18** | ITO 20 | - | 253,7 | 22,87 | 383 | 1,6259 | 9,72 | 0,103 |
| **19** | ITO 20 | 240 °C | 17,5 | 0,29 | 387 | 1,5859 | 0,68 | 1,478 |
| **20** | ITO 20 | 550°C | 7,5 | 0,43 | 350 | 1,5004 | 0,26 | 3,831 |
| **21** | ITO 30 | - | 32,8 | 1,03 | 885 | 1,6299 | 2,90 | 0,344 |
| **22** | ITO 30 | - | 50,2 | 1,39 | 647 | 1,6141 | 3,25 | 0,308 |
| **23** | ITO 30 | 240 °C | 4,4 | 0,10 | 620 | 1,5817 | 0,27 | 3,705 |
| **24** | ITO 30 | 550°C | 1,7 | 0,09 | 563 | 1,5167 | 0,10 | 10,192 |
| **25** | ITO 40 | - | 13,9 | 0,15 | 1618 | 1,6339 | 2,25 | 0,444 |
| **26** | ITO 40 | - | 21,9 | 0,36 | 1191 | 1,6342 | 2,61 | 0,383 |
| **27** | ITO 40 | 240 °C | 2,5 | 0,13 | 1152 | 1,5971 | 0,28 | 3,515 |
| **28** | ITO 40 | 550 °C | 0,9 | 0,02 | 1048 | 1,5189 | 0,09 | 11,085 |

| | | | | | | | | |
|---|---|---|---|---|---|---|---|---|
| n.m. : nicht gemessen. | | | | | | | | |

### Tabelle 11 (Fortsetzung)

**Tabelle 12**

| | | | *Transmission* **%** | | *Haze* **%** | | *Clarity* **%** | |
|---|---|---|---|---|---|---|---|---|
| Nr. | | Nachbehandlung | Mittelwert | *St. abw.* | Mittelwert | *St. abw.* | Mittelwert | *St. abw.* |
| **1** | ITS 05 | - | 92,30 | *0,06* | 1,59 | *0,04* | 99,00 | *0,15* |
| **2** | ITS 05 | - | 91,90 | *0,35* | 3,08 | *0,44* | 97,40 | *0,45* |
| **3** | ITS 05 | 240 °C | 92,00 | *0,06* | 1,53 | *0,61* | 98,80 | *0,10* |
| **4** | ITS 05 | 550° | 93,20 | *0,00* | 1,44 | *0,03* | 99,10 | *0,10* |
| **5** | ITS 10 | - | 90,00 | *3,26* | 1,49 | *0,16* | 99,30 | *0,12* |
| **6** | ITS 10 | - | 92,60 | *0,10* | 1,65 | *0,07* | 99,00 | *0,17* |
| **7** | ITS 10 | 240 °C | 91,60 | *0,06* | 1,66 | *0,10* | 99,00 | *0,06* |
| **8** | ITS 10 | 550° | 92,30 | *0,06* | 1,42 | *0,00* | 99,30 | *0,10* |
| **9** | ITS 20 | - | 90,80 | *0,06* | 2,25 | *0,10* | 98,00 | *0,30* |
| **10** | ITS 20 | - | 91,20 | *0,06* | 1,87 | *0,04* | 98,30 | *0,31* |
| **11** | ITS 20 | 240 °C | 89,80 | *0,10* | 2,16 | *0,00* | 98,60 | *0,17* |
| **12** | ITS 20 | 550° | 91,20 | *0,00* | 2,55 | *0,06* | 98,80 | *0,06* |
| **13** | ITS 30 | - | 88,90 | *0,71* | 7,09 | *0,75* | 92,70 | *1,00* |
| **14** | ITS 30 | - | 90,20 | *0,06* | 5,65 | *0,34* | 95,20 | *0,70* |
| **15** | ITS 30 | 240 °C | 88 | *0,32* | 8,62 | *0,3* | 95,5 | 0,7 |
| **16** | ITS 30 | 550° | 88,10 | *0,21* | 12,00 | *0,98* | 94,30 | *0,15* |
| **17** | ITO 20 | - | 91,10 | *0,06* | 1,49 | *0,00* | 99,00 | *0,06* |
| **18** | ITO 20 | - | 91,30 | *0,00* | 2,74 | *0,00* | 98,70 | *0,00* |
| **19** | ITO 20 | 240 °C | 92,00 | *0,00* | 2,51 | *0,00* | 98,80 | *0,06* |
| **20** | ITO 20 | 550° | 93,10 | *0,06* | 1,49 | *0,09* | 99,20 | *0,10* |
| **21** | ITO 30 | - | 90,50 | *0,40* | 0,89 | *0,07* | 99,50 | 0,00 |
| **22** | ITO 30 | - | 91,60 | *0,21* | 1,34 | *0,03* | 99,30 | *0,00* |
| **23** | ITO 30 | 240 °C | 91,70 | *0,06* | 1,31 | *0,11* | 99,30 | *0,00* |
| **24** | ITO 30 | 550° | 93,00 | *0,06* | 0,94 | *0,05* | 99,50 | *0,06* |
| **25** | ITO 40 | - | 88,80 | *0,15* | 0,69 | *0,13* | 99,40 | *0,00* |
| **26** | ITO 40 | - | 89,90 | *0,06* | 0,63 | *0,03* | 99,30 | *0,06* |
| **27** | ITO 40 | 240 °C | 91,10 | *0,06* | 0,64 | *0,35* | 99,20 | *0,06* |
| **28** | ITO 40 | 550° | 92,50 | *0,06* | 1,04 | *0,00* | 99,50 | *0,06* |

## Patentansprüche

1. Verfahren zur Herstellung einer Beschichtung oder eines Formkörpers auf der Basis von Indium-Zinn-Oxid (ITO), enthaltend die folgenden Schritte:
a) Herstellung einer Zusammensetzung enthaltend
a1) ITO-Nanopartikel und
a2) mindestens eine hydrolysierbare Verbindung der 4., 5., 6., 13. oder 14. Gruppe des Periodensystems ;
a3) mindestens ein organisch modifiziertes anorganisches Bindemittel;
b) Auftragen der Beschichtungszusammensetzung auf ein Substrat oder Einbringen der Zusammensetzung in einer Form;
c) Härten der Zusammensetzung, wobei das Härten eine Temperaturbehandlung bei 200 °C bis 600 °C umfasst.

2. Verfahren nach Anspruch 1, **dadurch gekennzeichnet, dass** die ITO-Nanopartikel oberflächenmodifiziert sind.

3. Verfahren nach einem der Ansprüche 1 oder 2, **dadurch gekennzeichnet, dass**
die Zusammensetzung zwischen 1 und 30 Gew.-% mindestens der hydrolysierbaren Verbindung der 4., 5., 6., 13. oder 14. Gruppe des Periodensystems enthält berechnet als das zugehörige Oxid der Verbindung bezogen auf den Gehalt an ITO-Nanopartikeln.

4. Verfahren nach einem der vorhergehenden Ansprüche,
**dadurch gekennzeichnet, dass**
die hydrolysierbare Verbindung eine Verbindung der Formel
MXₐ
ist, wobei M ein Metall ist, X ein hydrolysierbarer Rest darstellt und a der Wertigkeit von M entspricht, wobei M Ti, Zr, Al oder Sn ist.

5. Verfahren nach Anspruch 4, **dadurch gekennzeichnet, dass**
X ausgewählt ist aus der Gruppe umfassend Halogenatome, Alkoxygruppen, Alkylcarbonylgruppen oder Acyloxygruppen.

6. Verfahren nach einem der vorhergehenden Ansprüche,
**dadurch gekennzeichnet, dass**
das organisch modifizierte anorganische Bindemittel mindestens ein hydrolysierbares Silan der Formel RₙSiX₄₋ₙ umfasst, wobei X hydrolysierbare Reste darstellen und R ein nicht hydrolysierbarer Rest darstellt, wobei n für 1, 2 oder 3 steht.

7. Verfahren nach Anspruch 6, **dadurch gekennzeichnet, dass**
der nicht hydrolysierbare Rest mindestens eine funktionelle Gruppe aufweist, über die eine Vernetzung möglich ist.

8. Verfahren nach einem der vorhergehenden Ansprüche,
**dadurch gekennzeichnet, dass**
die Zusammensetzung nur ein oder mehrere organisch modifizierte anorganische Bindemittel aufweist.

9. Verfahren nach einem der vorhergehenden Ansprüche,
**dadurch gekennzeichnet, dass**
der Gehalt an ITO-Nanopartikeln in der gehärteten Schicht oder Formkörper über 70 Gew.-% liegt.

10. Verfahren nach einem der vorhergehenden Ansprüche,
**dadurch gekennzeichnet, dass**
das Härten der Beschichtung auch durch UV-Licht erfolgt.

11. Verfahren nach einem der vorhergehenden Ansprüche,
**dadurch gekennzeichnet, dass**
nach dem Härten eine Temperaturbehandlung bei Temperaturen von 200 bis 600 °C erfolgt.

12. Verfahren nach einem der vorhergehenden Ansprüche,
**dadurch gekennzeichnet, dass**
im gehärteten Zustand der Gehalt an Bindemittel bezogen auf die anorganischen Bestandteile zwischen 1 und 20 Gew.-% der Schicht beträgt, bezogen auf das Oxid des jeweiligen Bindemittels..

13. Beschichtungen oder Formkörper erhältlich nach einem der Ansprüche 1 bis 12.

14. Artikel enthaltend eine Beschichtung nach einem der Ansprüche 1 bis 12.

15. Verwendung einer Beschichtung oder eines Formkörpers nach Anspruch 13 oder eines Artikels nach Anspruch 14 für mikro- und/oder optoelektronische Zwecke.

## Claims

1. Process for producing a coating or a shaped body based on indium tin oxide (ITO), comprising the following steps:
a) producing a composition comprising
a1) ITO nanoparticles and
a2) at least one hydrolysable compound of group 4, 5, 6, 13 or 14 of the Periodic Table;
a3) at least one organically modified inorganic binder;
b) applying the coating composition to a substrate or introducing the composition into a mould;
c) hardening the composition, where the hardening comprises a thermal treatment at 200°C to 600°C.

2. Process according to Claim 1, **characterized in that**
the ITO nanoparticles have been surface-modified.

3. Process according to either of Claims 1 and 2, **characterized in that**
the composition contains between 1% and 30% by weight of at least the hydrolysable compound of group 4, 5, 6, 13 or 14 of the Periodic Table, calculated as the corresponding oxide of the compound, based on the content of ITO nanoparticles.

4. Process according to any of the preceding claims, **characterized in that**
the hydrolysable compound is a compound of the formula
MXa
where M is a metal, X represents a hydrolysable radical and a corresponds to the valency of M, where M is Ti, Zr, Al or Sn.

5. Process according to Claim 4, **characterized in that**
X is selected from the group comprising halogen atoms, alkoxy groups, alkylcarbonyl groups and acyloxy groups.

6. Process according to any of the preceding claims, **characterized in that**
the organically modified inorganic binder comprises at least one hydrolysable silane of the formula RₙSiX₄₋ₙ, X representing hydrolysable radicals and R representing a non-hydrolysable radical, where n is 1, 2 or 3.

7. Process according to Claim 6, **characterized in that**
the non-hydrolysable radical has at least one functional group via which crosslinking is possible.

8. Process according to any of the preceding claims, **characterized in that**
the composition includes only one or more than one organically modified inorganic binder.

9. Process according to any of the preceding claims, **characterized in that**
the content of ITO nanoparticles in the hardened layer or shaped body is more than 70% by weight.

10. Process according to any of the preceding claims, **characterized in that**
the hardening of the coating is also effected by means of UV light.

11. Process according to any of the preceding claims, **characterized in that**
the hardening is followed by a thermal treatment at temperatures of 200 to 600°C.

12. Process according to any of the preceding claims, **characterized in that**
in the hardened state the content of binder based on the inorganic constituents is between 1% and 20% by weight of the layer, based on the oxide of the respective binder.

13. Coatings or shaped bodies obtainable according to any of Claims 1 to 12.

14. Article comprising a coating according to any of Claims 1 to 12.

15. Use of a coating or a shaped body according to Claim 13 or of an article according to Claim 14 for micro- and/or optoelectronic purposes.

## Revendications

1. Procédé de fabrication d'un revêtement ou d'un corps moulé à base d'oxyde d'indium-étain (ITO), contenant les étapes suivantes :
a) la fabrication d'une composition contenant :
a1) des nanoparticules d'ITO et
a2) au moins un composé hydrolysable du groupe 4, 5, 6, 13 ou 14 du tableau périodique ;
a3) au moins un liant inorganique modifié organiquement ;
b) l'application de la composition de revêtement sur un substrat ou l'introduction de la composition dans un moule ;
c) le durcissement de la composition, le durcissement comprenant un traitement thermique à une température de 200 °C à 600 °C.

2. Procédé selon la revendication 1, **caractérisé en ce que** les nanoparticules d'ITO sont modifiées en surface.

3. Procédé selon l'une quelconque des revendications 1 ou 2, **caractérisé en ce que** la composition contient entre 1 et 30 % en poids dudit au moins un composé hydrolysable du groupe 4, 5, 6, 13 ou 14 du tableau périodique, calculé sous la forme de l'oxyde correspondant au composé par rapport à la teneur en nanoparticules d'ITO.

4. Procédé selon l'une quelconque des revendications précédentes, **caractérisé en ce que** le composé hydrolysable est un composé de formule :
MXa
dans laquelle M est un métal, X représente un radical hydrolysable et a correspond à la valence de M, M étant Ti, Zr, Al ou Sn.

5. Procédé selon la revendication 4, **caractérisé en ce que** X est choisi dans le groupe comprenant les atomes d'halogène, les groupes alcoxy, les groupes alkylcarbonyle ou les groupes acyloxy.

6. Procédé selon l'une quelconque des revendications précédentes, **caractérisé en ce que** le liant inorganique modifié organiquement comprend au moins un silane hydrolysable de formule RₙSiX₄₋ₙ, les X représentant des radicaux hydrolysables et R représentant un radical non hydrolysable, n représentant 1, 2 ou 3.

7. Procédé selon la revendication 6, **caractérisé en ce que** le radical non hydrolysable comprend au moins un groupe fonctionnel par le biais duquel une réticulation est possible.

8. Procédé selon l'une quelconque des revendications précédentes, **caractérisé en ce que** la composition comprend uniquement un ou plusieurs liants inorganiques modifiés organiquement.

9. Procédé selon l'une quelconque des revendications précédentes, **caractérisé en ce que** la teneur en nanoparticules d'ITO dans la couche ou le corps moulé durci est supérieure à 70 % en poids.

10. Procédé selon l'une quelconque des revendications précédentes, **caractérisé en ce que** le durcissement du revêtement a également lieu par lumière UV.

11. Procédé selon l'une quelconque des revendications précédentes, **caractérisé en ce qu'**un traitement thermique à des températures de 200 à 600 °C a lieu après le durcissement.

12. Procédé selon l'une quelconque des revendications précédentes, **caractérisé en ce que** à l'état durci la teneur en liant par rapport aux constituants inorganiques est comprise entre 1 et 20 % en poids de la couche, par rapport à l'oxyde du liant en question.

13. Revêtements ou corps moulés pouvant être obtenus selon l'une quelconque des revendications 1 à 12.

14. Article contenant un revêtement selon l'une quelconque des revendications 1 à 12.

15. Utilisation d'un revêtement ou d'un corps moulé selon la revendication 13 ou d'un article selon la revendication 14 à des fins micro- et/ou optoélectroniques.
